(19) Europäisches Patentamt
European Patent Office
Office européen des brevets

(11) **EP 1 795 258 A1**

(12) **EUROPEAN PATENT APPLICATION**
published in accordance with Art. 158(3) EPC

(43) Date of publication:
**13.06.2007 Bulletin 2007/24**

(51) Int Cl.:
**B01J 19/00** *(2006.01)* **B81B 1/00** *(2006.01)*
**G01N 35/08** *(2006.01)* **G01N 37/00** *(2006.01)*

(21) Application number: **05748721.7**

(22) Date of filing: **07.06.2005**

(86) International application number:
**PCT/JP2005/010432**

(87) International publication number:
**WO 2005/120696 (22.12.2005 Gazette 2005/51)**

(84) Designated Contracting States:
**AT BE BG CH CY CZ DE DK EE ES FI FR GB GR HU IE IS IT LI LT LU MC NL PL PT RO SE SI SK TR**

(30) Priority: **07.06.2004 JP 2004214992**

(71) Applicant: **NANO Fusion Technologies, Inc.**
**Tokyo 153-0065 (JP)**

(72) Inventors:
• **NISHIKAWA, Masana**
**Meguro-ku, Tokyo 1530065 (JP)**

• **YANAGISAWA, Ichiro c/o NANO FUSION TECHN. INC.**
**Meguro-ku, Tokyo 1530065 (JP)**

(74) Representative: **Höhfeld, Jochen**
**Klunker Schmitt-Nilson Hirsch**
**Patentanwälte**
**Winzererstrasse 106**
**D-80797 München (DE)**

(54) **ELECTROOSMOTIC FLOW PUMP SYSTEM AND ELECTROOSMOTIC FLOW PUMP**

(57)    A projection (35) is formed on a pump body (24) of an electroosmotic flow pump (14a-14d) so as to face a communication hole (36) of a micro fluid chip (12). When the projection (35) and the communication hole (36) are fitted together, a first flow path (22) of the pump (14a-14d) and a second flow path (18) of the micro fluid chip (12) are communicated and the pump (14a- 14d) is fixed to the micro fluid chip (12). At the same time, the connection between the first flow path (22) and the second flow path (18) is sealed to prevent leakage of liquid (38, 40), gas (42), etc. to the outside.

FIG. 2

EP 1 795 258 A1

**Description**

TECHNICAL FIELD

The present invention relates to an electroosmotic pump system and an electroosmotic pump for supplying a fluid to or drawing a fluid from a microfluidic chip thereby to control the fluid in the microfluidic chip, e.g., to control the flow rate, pressure, and level of the fluid in the microfluidic chip.

BACKGROUND ART

Microfluidic chips are used to provide microscale fluid passages and various fluid control devices on plastic or glass chips for causing chemical reactions or biochemical reactions to occur in the fluid control devices. Use of a microfluidic chip is effective to reduce the size of a system for developing chemical reactions or biochemical reactions and also to greatly reduce the amounts of a sample and a reagent required in such chemical reactions or biochemical reactions. As a result, the time required by the system for measurements and the power consumption of the system can be reduced.

The system needs a pump for driving the fluid in the microfluidic chip. In order to make the microfluidic chip practical in the system, it is necessary not only to develop microfluidic chip designs, but also to optimize the system in its entirety or stated otherwise to reduce the size and cost of the system in its entirety, which includes a process of introducing a sample into the microfluidic chip, a pump for driving the fluid, a power supply, a measurement system, etc.

Two methods of supplying a liquid into a microfluidic chip and driving the supplied liquid will be described below.

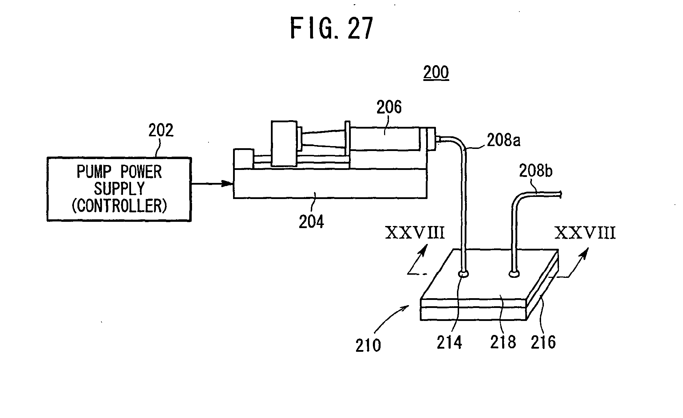

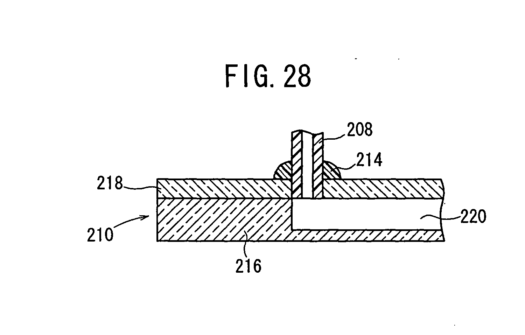

According to the first method, as shown in FIG. 27, a pump power supply 202 of a pump system 200 energizes a syringe pump drive unit 204 to actuate a syringe pump 206 to supply a liquid from the syringe pump 206 through a small-diameter tube 208a to a microfluidic chip 210. As shown in FIGS. 27 and 28, the tube 208a is bonded to the microfluidic chip 210 by an adhesive 214, thereby providing a seal between the microfluidic chip 210 and the tube 208a.

The microfluidic chip 210 comprises a lower glass substrate 216 and an upper glass substrate 218 which are bonded to each other. The glass substrate 216 has a groove defined therein as a fluid passage 220. The liquid that has been used by the microfluidic chip 210 is discharged to a waste liquid reservoir through a tube 208b. The liquid may be discharged from the microfluidic chip 210 through the tube 208b by devices similar to the pump power supply 202, the syringe pump drive unit 204, and the syringe pump 206.

For making the microfluidic chip 210 more practical, it is necessary to package the microfluidic chip 210 in the same manner as with IC chips to physically secure the microfluidic chip 210 for thereby protecting the microfluidic chip 210 against dust, heat, moisture, and chemical contamination, and also to take into account interfaces for the supply of electric power, the inputting and outputting of signals, and the supply of the fluid.

There has been disclosed a conventional packaging system for securing the microfluidic chip 210 with a holder and a socket, and taking into account interfaces for the supply of the fluid, the supply of electric power, and the inputting and outputting of signals through the holder and the socket (see non-patent document 1).

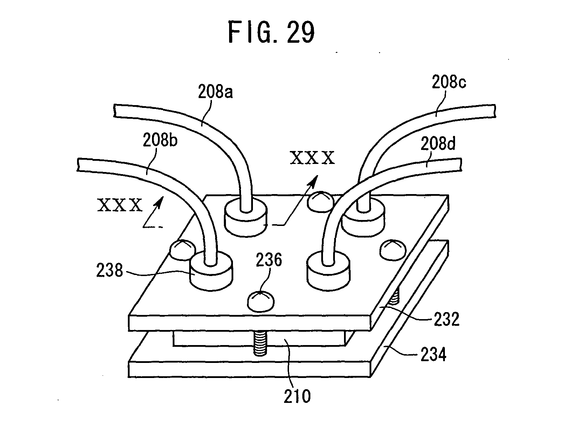

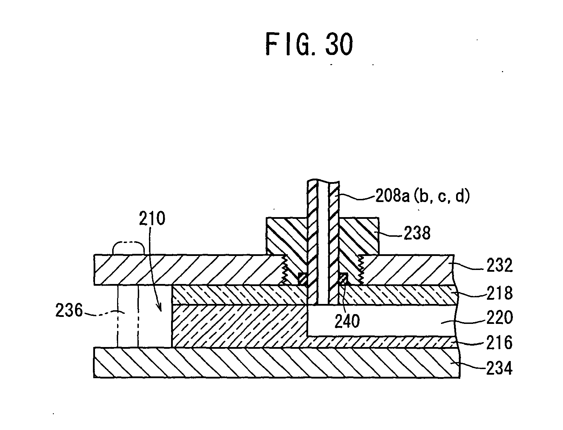

FIGS. 29 and 30 show the conventional packaging system for the microfluidic chip 210.

The microfluidic chip 210 is sandwiched by jigs 232, 234 of aluminum, and securely held in position by the jigs 232, 234 that are fastened to each other by screws 236. The tube 208a is connected to the microfluidic chip 210 by a screw 238 through which the tube 208a can be inserted. Specifically, when the screw 238 is threaded into the jig 232, an O-ring 240 in the screw 238 presses the upper surface of the microfluidic chip 210 (the upper surface of the glass substrate 218), thereby providing a seal between the tube 208a and the microfluidic chip 210. In FIG. 29, a plurality of tubes 208a through 208d are connected to the microfluidic chip 210 by a plurality of screws 238.

In the above pump system 200, the pump power supply 202, the syringe pump drive unit 204, and the syringe pump 206 have an overall size of about several tens [cm], and the tubes 208a through 208d have an overall length of about several tens [cm]. Even if the fluid interfaces are improved, therefore, the system cannot be reduced in overall size.

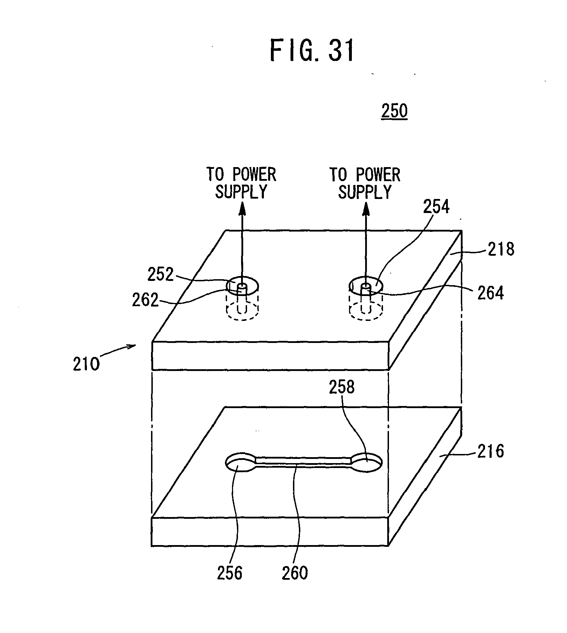

According to the second method, a microflow pump such as diaphragm pump, an electroosmotic pump, or the like is formed directly in the microfluidic chip 210 by the microfabrication technology. FIG. 31 shows a conventional electroosmotic pump system 250 incorporating an electroosmotic pump constructed using a fluid passage defined in the microfluidic chip 210.

In the electroosmotic pump system 250, grooves 256, 258 which provide bottom surfaces of liquid reservoirs (hereinafter referred to as "reservoirs") and a groove 260 interconnecting the grooves 256, 258 and having a width ranging from several [μm] to several tens [μm] are formed in the upper surface of the glass substrate 216, and through holes 252, 254 cooperating with the grooves 256, 258 in providing the reservoirs and having a diameter ranging from 1 [mm] to 2 [mm] are formed in the glass substrate 218. The upper surface of the glass substrate 216 and the lower surface of the glass substrate 218 are bonded to each other, an electrode 262 is inserted in the reservoir made up of the through hole 252 and the groove 256, and an electrode 264 is inserted in the reservoir made up of the through hole 254 and the groove 258, thereby providing an electroosmotic pump in the microfluidic chip 210.

However, the electroosmotic pump system 250 is problematic in that it poses limitations on the flow rate, pressure characteristics, etc. of the electroosmotic pump, it is difficult to machine the microfluidic chip 210, and, as a result, the electroosmotic pump system 250 is highly costly.

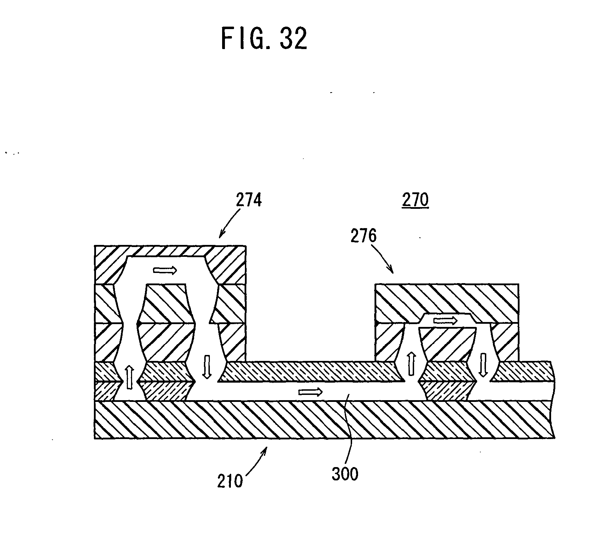

FIG. 32 shows a conventional pump system 270 having a diaphragm pump 274 constructed on the microfluidic chip 210 according to the microfabrication technology.

In the pump system 270, the diaphragm pump 274 and a flow meter 276 as modularized units are fabricated on the microfluidic chip 210, and are interconnected by a fluid passage 300 defined in the microfluidic chip 210. Though the internal interconnection in the microfluidic chip 210 between the components is simplified, the cost of microfabrication of the pump system 270 is high. The pump 274 is a pump for driving the fluid in the microfluidic chip 210, and another pump is required to supply the fluid to and draw the fluid from the microfluidic chip 210. Therefore, the pump system 270 needs to take into account interfaces for supplying the fluid from and discharging the fluid to an external source.

Non-patent document 1: Zhen Yang and Ryutaro Maeda, A world-to-chip socket for microfluidic prototype development, Electrophoresis 2002, 23, 3474-3478

Non-patent document 2: Michael Koch, Alan Evans and Arthur Brunnschweiler, Microfluidic Technology and Applications, Research Studies Press Inc., 2000

DISCLOSURE OF THE INVENTION

PROBLEMS TO BE SOLVED BY THE INVENTION

There are two merits obtained by using the microfluidic chip 210 (see FIGS. 27 through 32); (1) the entire system is reduced in size, and (2) the amount of a sample is reduced. If a pump which is sufficiently smaller than the microfluidic chip 210 is used, then the entire system including the power supply and the controller can be reduced in size. However, there is not available a small-size and inexpensive pump which is of a sufficient level of performance that can be used for controlling the fluid in the microfluidic chip 210. In other words, though the microfluidic chip 210 can be reduced in size, it is not possible to provide a system arrangement which enjoys the merits of the microfluidic chip 210.

These mechanical pumps are not inexpensive enough and suffer disadvantages in terms of fluid control as described later.

Specifically, according to the first method described above, the syringe pump 206 or a peristaltic pump that is used is large in size compared with the microfluidic chip 210. Even if it is possible to reduce the size of the microfluidic chip 210, it is difficult to reduce the entire system to a size small enough to make the system mobile.

If the drive pump and the microfluidic chip 210 can be reduced to a size of about 10 [cm], then it is possible to greatly improve the mobility of the entire system. For using the system with the microfluidic chip 210 in various applications, it is desirable to reduce the size of the system by maximizing the microscale nature of the microfluidic chip 210, thereby increasing the mobility of the system.

As described above, the amount of a sample used can be reduced by the microscale nature of the microfluidic chip 210. However, the existence of the tubes 208a through 208d between the pump and the microfluidic chip 210 is responsible for some deficiencies.

Specifically, the fluid passage 220 (see FIGS. 28 and 30) in the microfluidic chip 210 has a width in the range from several [μm] to several hundreds [μm]. In this case, the inventory of the fluid in the fluid passage 220 is often several [μl] or less. The syringe pump 206 or the peristaltic pump is frequently used as the pump disposed outside of the microfluidic chip 210. These pumps have a size of about several tens [cm]. As a result, the tubes 208a through 208d that are several tens [cm] or more are required to connect the pump to the microfluidic chip 210. If the tubes 208a through 208d have an inside diameter of 0.5 [mm] and a length of 20 [cm], then the inventory of the fluid in the tubes 208a through 208d is 39.25 [μl].

Even if the amount of a sample that is actually needed is 1 [μl/min], the pump system 200 constructed as described above requires that the tube 208a and the syringe pump 206 be filled with the sample in advance in order to introduce the sample into the microfluidic chip 210. Therefore, the entire system requires a sample in an amount of 40 [μl/min] or more. The excessive amount of the sample is not used in various chemical reactions in the microfluidic chip 210 and is wasted.

According to the first method, even though the amounts of the sample and the reagent used in the microfluidic chip 210 are small, since the amount of the liquid wasted in the tube 208a is large, the system fails to enjoy the essential advantage of the microfluidic chip 210 that the amount of the fluid used can be reduced.

As described above, the syringe pump 206 is disposed in a location spaced from the microfluidic chip 210, and the outlet port of the syringe pump 206 and the fluid inlet port of the fluid passage 220 are interconnected by the tube 208a, which is bonded to the glass substrate 218 by the adhesive 214. With this structure, the volume of the space from the syringe pump 206 to the fluid inlet port, i.e., the volume of the space in the tube 208a and the space in the fluid inlet port, is greater than the volume of the fluid passage 220.

A mode of operation for supplying a sample liquid from the syringe pump 206 to the microfluidic chip 210 and moving the sample liquid in the fluid passage 220 will be described below. In this mode of operation, a basic action is to stop supplying the sample liquid. If the syringe pump 206 controls the pressure of the sample liquid, then the sample liquid in the fluid passage 220 is not immediately stopped even when the syringe pump 206 is inactivated.

A first factor responsible for the above drawback is the pump itself. For example, if a mechanical pump such as the syringe pump 206 or the peristaltic pump is used, then because the actuatable component of the pump has a mechanical inertia, the driving pressure does not becomes 0 instantaneously even when the pump is inactivated.

Another more serious problem is that when a pressure for driving the fluid is applied to the sample liquid, the pressure causes the sample liquid to change in volume and also causes the tube 208a to be deformed. Though the volume change is eliminated when the pump is inactivated to stop moving the sample liquid, the change is responsible for moving the sample liquid even after the pump is inactivated.

For example, it is assumed that the sample liquid is water. If the space in which the sample liquid is present has a volume of 100 [$\mu$l] and a compression ratio $\kappa$ = 0.45 [GPa$^{-1}$] at 20°C, then a pressure change of 0.1 [MPa] causes the sample liquid to undergo a volume change of 4.5 [nl]. If the fluid passage 220 has a cross-sectional area of 100 [$\mu$m] x 50 [$\mu$m], then the volume change corresponds to a channel length of 1 [mm]

Since the volume of the sample liquid changes due to a temperature change even after the sample liquid is stopped, such a volume change causes a change in the pressure on the sample liquid and a change in the position of the sample liquid in the microfluidic chip 210. When a temperature change of 50 [°C] occurs, 100 [$\mu$l] of the sample liquid undergoes a volume change of 1 [$\mu$l] because of its coefficient of cubic expansion (0.21 $\times$ 10$^{-3}$ [K$^{-1}$] at 20 [°C]). If the syringe pump 206 drives a driving fluid to move the sample liquid in the fluid passage 220 through a gas, then the above various factors have significant effects.

If small amounts of the sample liquid and the drive liquid are handled in the microscale fluid passage 220, a large space (dead space) from the pump (syringe pump 206) as a pressure source to the fluid passage 220 in the microfluidic chip 210 has a large effect on the controllability of the liquids in the fluid passage 220.

According to the second method, the diaphragm pump 274 or an electroosmotic pump is formed on the microfluidic chip 210. Since the pump 274 is of a complex structure, its cost is high if it is fabricated according to the microfabrication technology. Another problem is that the pump 274, which is a dynamic device, tends to suffer failures and to generate a pulsating flow.

Heretofore, an electroosmotic pump for use in the microfluidic chip 210 is simple in structure and can relatively easily be fabricated in the microfluidic chip 210 according to the microfabrication technology. However, inasmuch as the performance of the electroosmotic pump depends strongly upon the channel dimensions (width and depth) of the fluid passage, the flow rate in the fluid passage is limited, and the applied voltage is of a high level on the order of [kV].

As described above, there is a need for a pump means for introducing a liquid into the microfluidic chip 210. In this case, the liquid is introduced from an external reservoir through the tube 208a into the microfluidic chip 210. If the reservoir is installed at a location remote from the microfluidic chip 210, then the sample and the reagent cannot be handled in small amounts as with the first method.

Furthermore, if the pump in the microfluidic chip 210 does not have a self-priming capability, then the microfluidic chip 210 needs to be initially primed with the fluid by an external pump.

The present invention has been made in efforts to solve the above problem. It is an object of the present invention to provide an electroosmotic pump system and an electroosmotic pump which are small in overall size for increased mobility, use a reduced amount of liquid for highly accurate positional control on a minute amount of liquid in a microfluidic chip, and are low in cost and practical.

MEANS FOR SOLVING THE PROBLEMS

An electroosmotic pump system according to the present invention comprises an electroosmotic pump having an electroosmotic member disposed in a first fluid passage, a first electrode disposed on an upstream side of the electroosmotic member, and a second electrode disposed on a downstream side of the electroosmotic member, with a discharge port being defined downstream of the second electrode, and a microfluidic chip having a second fluid passage defined therein, wherein the electroosmotic pump has on an outer peripheral surface thereof an attachment for mounting the electroosmotic pump on the microfluidic chip, and when the electroosmotic pump is mounted on the microfluidic chip by the attachment, the first fluid passage is held in fluid communication with the second fluid passage through the discharge port, and a fluid between the first fluid passage and the second fluid passage is prevented from leaking.

With the above arrangement, the electroosmotic pump and the microfluidic chip are separate from each other, and the electroosmotic pump is directly mounted on the microfluidic chip by the attachment. The electroosmotic pump and the microfluidic chip are integrally combined with each other from the standpoint of reducing the size of the entire system. If the electroosmotic pump and the microfluidic chip are general-purpose products, then the entire system can be constructed at a low cost. Stated otherwise, the small-size electroosmotic pump is disposed more closely to the microfluidic chip than with the conventional arrangements. As a result, the entire system can be reduced in size for increased system mobility. Since the electroosmotic pump is detachably mounted on the microfluidic chip, the general versatility is increased and the entire system is low in cost.

Because the electroosmotic pump is directly mounted on the microfluidic chip, the tubes employed in the conventional arrangements are not required. As a result, the reagent is not wasted, and the minute amount of the fluid in the second fluid passage can be controlled with high accuracy. According to the present invention, therefore, more practical fluid control can be achieved at a lower cost than with the conventional arrangements.

Furthermore, the attachment functions as an interface for securing the electroosmotic pump to the microfluidic chip and also as an interface for supplying and drawing in the fluid between the electroosmotic pump and the microfluidic chip. Consequently, the overall system arrangement is simplified.

Preferably, the attachment comprises a boss projecting toward the microfluidic chip and fittable in the second fluid passage or a recess defined in confronting relation to the microfluidic chip and fittable over the microfluidic chip, and the discharge port is defined in the boss or the recess.

When the boss or the recess and the second fluid passage are held in fitting engagement with each other, the first fluid passage is held in fluid communication with the second fluid passage through the discharge port, and the electroosmotic pump is directly mounted on the microfluidic chip. Therefore, when the boss or the recess and the second fluid passage are simply held in fitting engagement with each other, a seal is simply provided between the electroosmotic pump and the microfluidic chip. The fluid can reliably be supplied from the electroosmotic pump to the microfluidic chip or drawn from the microfluidic chip into electroosmotic pump.

Preferably, the attachment has a first terminal electrically connected to the first electrode and a second terminal electrically connected to the second electrode, the microfluidic chip has on a surface thereof a third terminal confronting the first terminal and a fourth terminal confronting the second terminal, and when the electroosmotic pump is mounted on the microfluidic chip by the attachment, the first terminal and the third terminal are connected to each other, and the second terminal and the fourth terminal are connected to each other.

When the electroosmotic pump is directly mounted on the microfluidic chip through the attachment, the third terminal is electrically connected to the first electrode through the first terminal, and the fourth terminal is electrically connected to the second electrode through the second terminal. If the third terminal and the fourth terminal are electrically connected to an external power supply, then the power supply can apply a voltage of one polarity to the first electrode through the third terminal and the first terminal and a voltage of the opposite polarity to the second electrode through the fourth terminal and the second terminal, thereby actuating the electroosmotic pump. Therefore, the attachment functions as an interface for securing the electroosmotic pump to the microfluidic chip, an interface for supplying and drawing in the fluid between the electroosmotic pump and the microfluidic chip, and an interface for supplying electric power. Consequently, the entire system is simplified.

An electroosmotic pump system according to the present invention comprises an electroosmotic pump having an electroosmotic member disposed in a first fluid passage, a first electrode disposed on an upstream side of the electroosmotic member, and a second electrode disposed on a downstream side of the electroosmotic member, with a discharge port being defined downstream of the second electrode, a microfluidic chip having a second fluid passage defined therein, and a holder member holding the microfluidic chip and the electroosmotic pump, wherein the electroosmotic pump has on an outer peripheral surface thereof an attachment for mounting the electroosmotic pump on at least the holder member, and when the microfluidic chip is mounted on the holder member and the electroosmotic pump is mounted on the holder member by the attachment, the first fluid passage is held in fluid communication with the second fluid passage through the discharge port, and a fluid between the first fluid passage and the second fluid passage is prevented from leaking.

With the above arrangement, the electroosmotic pump, the microfluidic chip, and the holder member are separate from each other. The electroosmotic pump is mounted on the holder member by the attachment, and the microfluidic chip is held on the holder member.

The electroosmotic pump, the microfluidic chip, and the holder member are integrally combined with each other from the standpoint of reducing the size of the entire system. If the electroosmotic pump, the microfluidic chip, and the holder member are general-purpose products, then the entire system can be constructed at a low cost. Stated otherwise, the small-size electroosmotic pump is disposed more closely to the microfluidic chip by the holder member than with the conventional arrangements. As a result, the entire system can be reduced in size for increased system mobility. Since the microfluidic chip and the electroosmotic pump are detachably mounted on the holder member, the general versatility is increased and the entire system is low in cost.

Because the electroosmotic pump is mounted on the holder member which holds the microfluidic chip, the distance between the electroosmotic pump and the microfluidic chip is smaller than with the conventional arrangements. As a consequence, the amount of a reagent which is wasted is reduced, and the minute amount of a fluid which is present in the second fluid passage can be controlled with high accuracy. According to the present embodiment, therefore, more practical fluid control can be achieved at a lower cost than with the conventional arrangements.

Furthermore, the attachment functions as an interface for securing the electroosmotic pump to the holder member and also as an interface for supplying and drawing in the fluid between the electroosmotic pump and the microfluidic chip. Consequently, the overall system arrangement is simplified.

The electroosmotic pump system described above has either one of the following four structures depending on how the electroosmotic pump is mounted on the holder member.

According to the first structure, the attachment electrically and mechanically interconnects the electroosmotic pump and the holder member.

Specifically, the attachment has a first terminal electrically connected to the first electrode and a second terminal electrically connected to the second electrode, the microfluidic chip has on a surface thereof a third terminal connectable to the first terminal and a fourth terminal connectable to the second terminal, and when the electroosmotic pump is mounted on the microfluidic chip by the attachment, the first terminal and the third terminal are connected to each other, and the second terminal and the fourth terminal are connected to each other.

When the electroosmotic pump is mounted on the holder member through the attachment, the third terminal is electrically connected to the first electrode through the first terminal, and the fourth terminal is electrically connected to the second electrode through the second terminal. If the third terminal and the fourth terminal are electrically connected to an external power supply, then the power supply can apply a voltage of one polarity to the first electrode through the third terminal and the first terminal and a voltage of the opposite polarity to the second electrode through the fourth terminal and the second terminal, thereby actuating the electroosmotic pump. Therefore, the attachment functions as an interface for securing the electroosmotic pump to the holder member, an interface for supplying and drawing in the fluid between the electroosmotic pump and the microfluidic chip, and an interface for supplying electric power. Consequently, the entire system is simplified.

According to the second structure, the attachment is connected to the holder member through an electric connector.

Specifically, the attachment has a seal member disposed in confronting relation to the microfluidic chip and surrounding the discharge port, a first terminal electrically connected to the first electrode, and a second terminal electrically connected to the second electrode, the electroosmotic pump is held by the holder member through an electric connector having a third terminal connectable to the first terminal and a fourth terminal connectable to the second terminal, and when the electric connector is secured to the holder member, the electric connector presses the microfluidic chip through the electroosmotic pump, and the seal member provides a seal between the electroosmotic pump and the microfluidic chip.

When the electric connector and the electroosmotic pump are held in fitting engagement with each other through the first through fourth terminals and the electric connector is secured to the holder member, the electroosmotic pump presses the microfluidic chip to provide a seal between the electroosmotic pump and the microfluidic chip. Therefore, the seal member serves as an interface for supplying and drawing in the fluid between the electroosmotic pump and the microfluidic chip, the first and second terminals as an interface for securing the electroosmotic pump to the holder member through the electric connector, and also as an interface for supplying electric power which is electrically connected to an external power supply through the third terminal and the fourth terminal. Therefore, the overall system is simplified.

The third structure is a structure for accommodating the electroosmotic pump in the holder member.

Specifically, the attachment has a seal member disposed in confronting relation to the microfluidic chip and surrounding the discharge port, a first terminal electrically connected to the first electrode, and a second terminal electrically connected to the second electrode, the holder member has a recess defined therein for accommodating the microfluidic chip, a hole held in fluid communication with the recess and accommodating the electroosmotic pump, and a third terminal and a fourth terminal which are electrically connected to the first terminal and the second terminal, respectively, when the electroosmotic pump is accommodated in the hole, when the electroosmotic pump is accommodated in the hole and the microfluidic chip is accommodated in the recess, the microfluidic chip is sandwiched by the holder member and a presser, and the seal member provides a seal between the electroosmotic pump and the microfluidic chip when the presser presses the electroosmotic pump through the microfluidic chip.

When the presser presses the microfluidic chip and the electroosmotic pump, the attachment doubles as the above interfaces. Therefore, the overall system is simplified.

According to the fourth structure, the electroosmotic pump is partly inserted in the holder member, and the electroosmotic pump and the microfluidic chip are held in fluid communication with each other through a communication passage defined in the holder member.

Specifically, the attachment has a seal member disposed in confronting relation to the holder member and surrounding the discharge port, a first terminal confronting the holder member and electrically connected to the first electrode, and a second terminal confronting the holder member and electrically connected to the second electrode, the holder member has a recess defined therein for accommodating the microfluidic chip, a communication passage defined therein which accommodates therein a discharge port side of the electroosmotic pump and which is connected to the recess, a third terminal fittable over the first terminal, and a fourth terminal fittable over the second terminal, when the discharge port side of the electroosmotic pump is accommodated in the communication passage and the electroosmotic pump is mounted on the holder member by the attachment, the first terminal and the third terminal are connected to each other, the second terminal and the fourth terminal are connected to each other, and the seal member provides a seal between the electroosmotic pump and the holder member.

When the discharge port side of the electroosmotic pump is accommodated in the communication passage, the attachment doubles as the above interfaces. Therefore, the overall system is simplified.

In each of the above electroosmotic pump systems and the electroosmotic pump, the first fluid passage preferably has a liquid reservoir for being filled with a liquid supplied from an external source.

If the liquid reservoir is disposed upstream of the first fluid passage, then the liquid supplied to the liquid reservoir reaches an upstream end of the electroosmotic member due to its own weight or a capillary effect. Even if no voltage is applied between the first electrode and the second electrode, the liquid that has reached the upstream surface of the electroosmotic member penetrates the electroosmotic member due to a capillary effect therein, and reaches a downstream end of the electroosmotic member. Therefore, with the liquid reservoir being filled with the liquid in advance, no liquid supply lines are needed for supplying the liquid from an external source to the electroosmotic pump. The mobility of the entire system is thus further increased.

A lid covering the opening is effective to prevent the liquid from being evaporated from the liquid reservoir and also to prevent dust from entering the liquid after the liquid reservoir has been filled with the liquid.

Preferably, a space extending from the discharge port to the second fluid passage has a volume v in the range of 10 [nl] < v < 10 [$\mu$l], or a distance from the discharge port to the second fluid passage ranges from 5 [$\mu$m] to 50 [mm]. With the above numerical ranges, the dead space in the fluid interface is smaller than the fluid inventory in the microfluidic chip. Therefore, such numerical ranges are effective to improve the controllability of the fluid.

An electroosmotic pump according to the present invention has an electroosmotic member disposed in a first fluid passage, a first electrode disposed on an upstream side of the electroosmotic member, and a second electrode disposed on a downstream side of the electroosmotic member, with a discharge port being defined downstream of the second electrode, wherein the electroosmotic pump has on an outer peripheral surface thereof an attachment for mounting the electroosmotic pump on the microfluidic chip or mounting the electroosmotic pump on a holder member holding the microfluidic chip, and when the electroosmotic pump is mounted on the microfluidic chip or the holder member by the attachment, the first fluid passage is held in fluid communication with a second fluid passage defined in the microfluidic chip through the discharge port, and the attachment prevents a fluid between the first fluid passage and the second fluid passage from leaking.

BRIEF DESCRIPTION OF THE DRAWINGS

FIG. 1 is a perspective view of an electroosmotic pump system according to a first embodiment;
FIG. 2 is a cross-sectional view taken along line II - II of FIG. 1;
FIG. 3 is a cross-sectional view taken along line III - III of FIG. 1;
FIG. 4 is a cross-sectional view illustrative of an electroosmotic phenomenon in an electroosmotic member;
FIG. 5A is a graph showing the relationship between the drive voltage and the flow rate of the electroosmotic pump shown in FIG. 1;

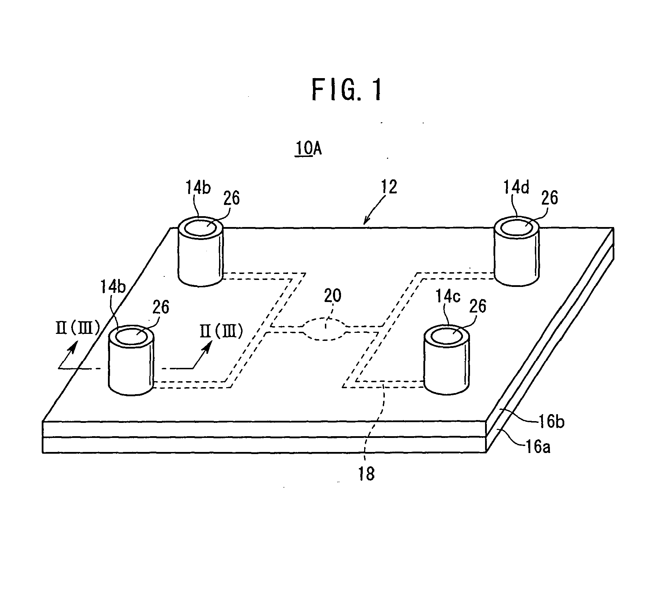

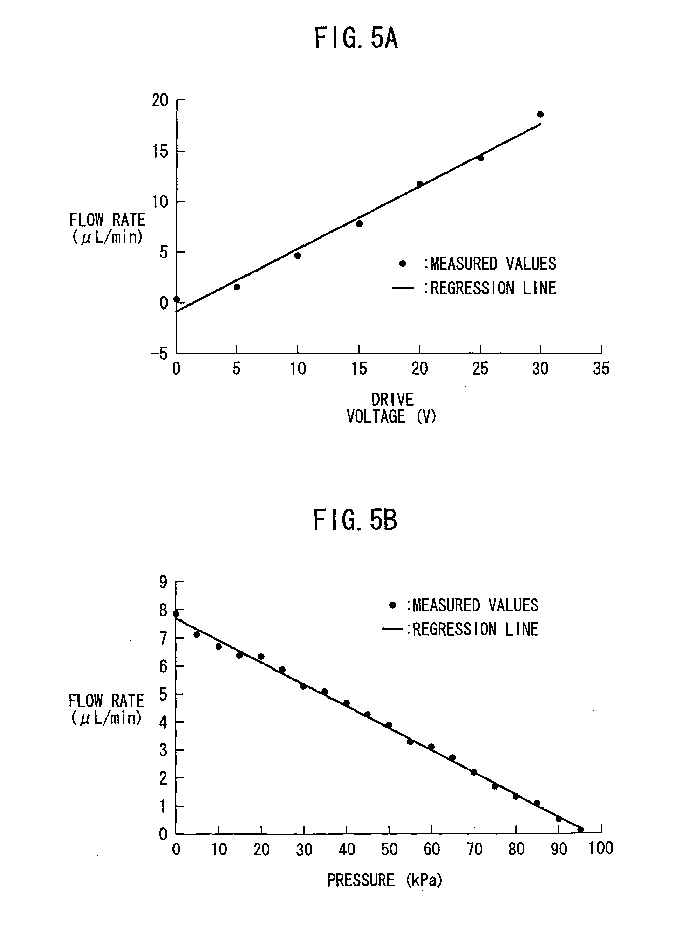

FIG. 5A is a graph showing the relationship between the pressure and the flow rate of the electroosmotic pump shown in FIG. 1;

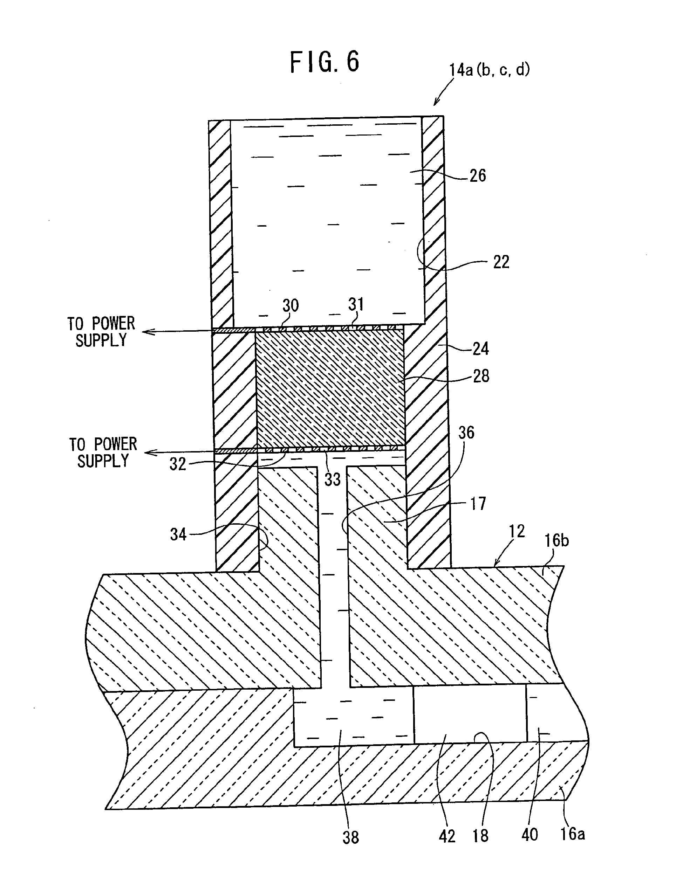

FIG. 6 is a cross-sectional view showing a microfluidic chip having a boss fitted in an outlet port of the electroosmotic pump;

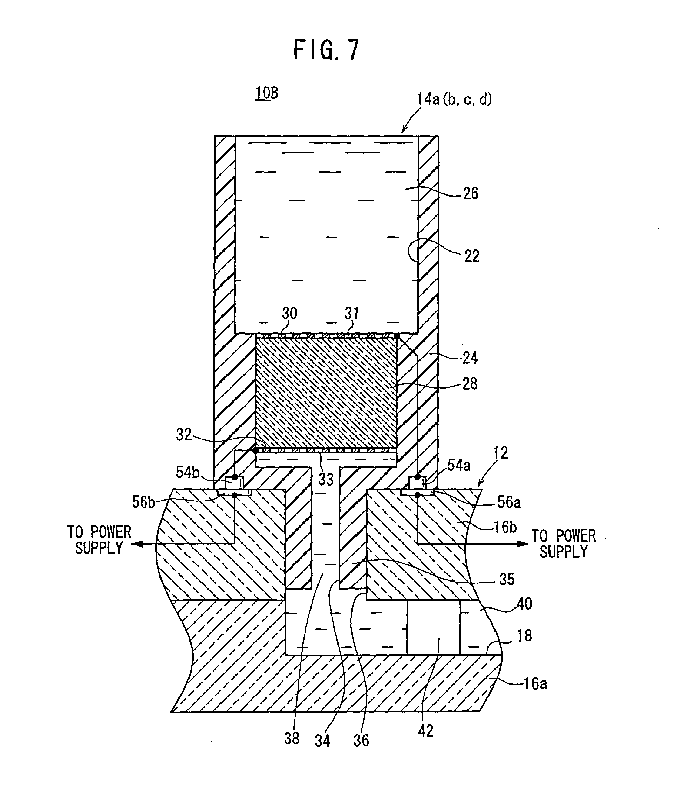

FIG. 7 is a cross-sectional view of an electroosmotic pump system according to a second embodiment;

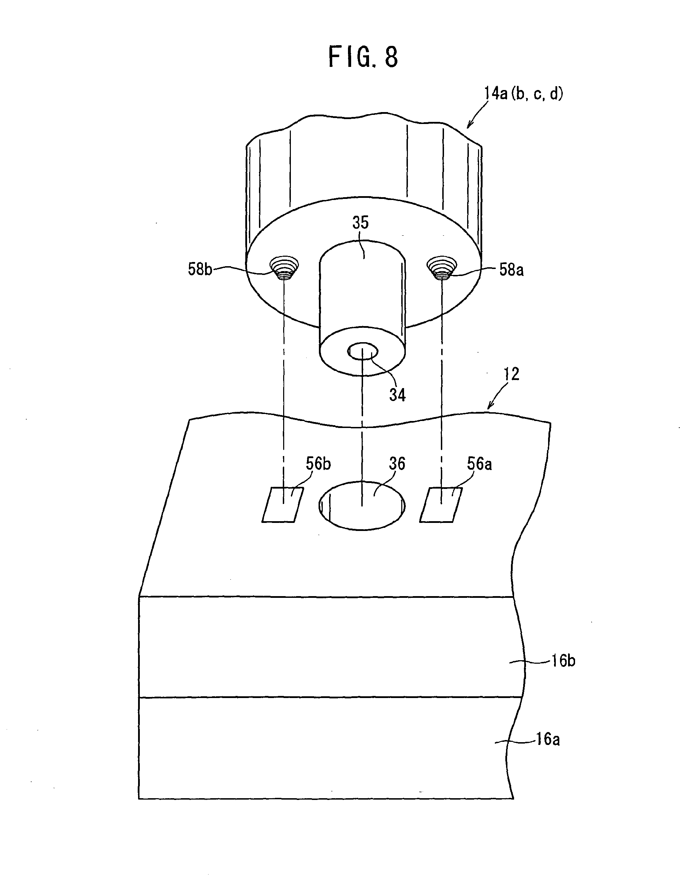

FIG. 8 is a perspective view showing spiral springs used as first and second terminals shown in FIG. 7;

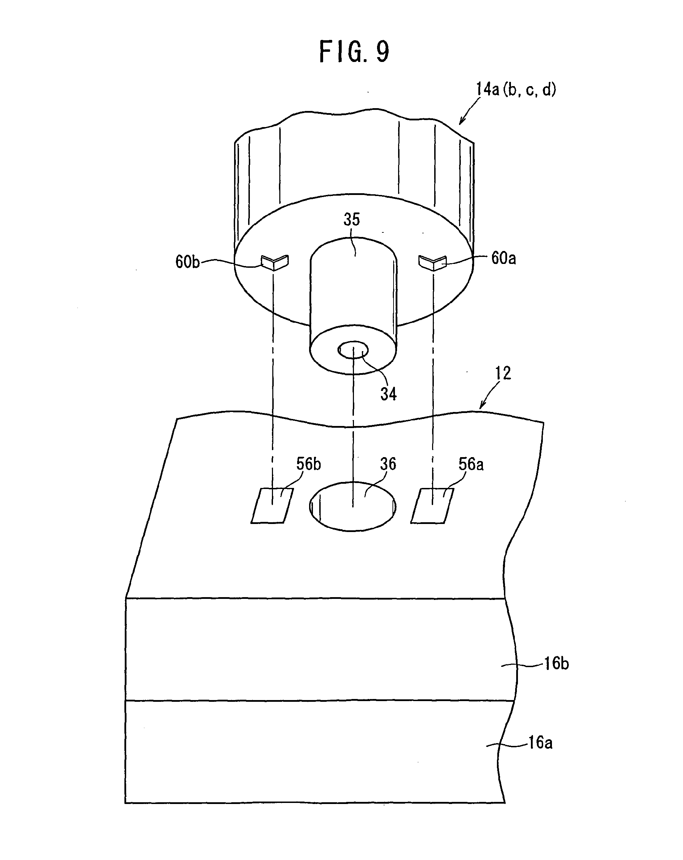

FIG. 9 is a perspective view showing leaf springs used as the first and second terminals shown in FIG. 7;

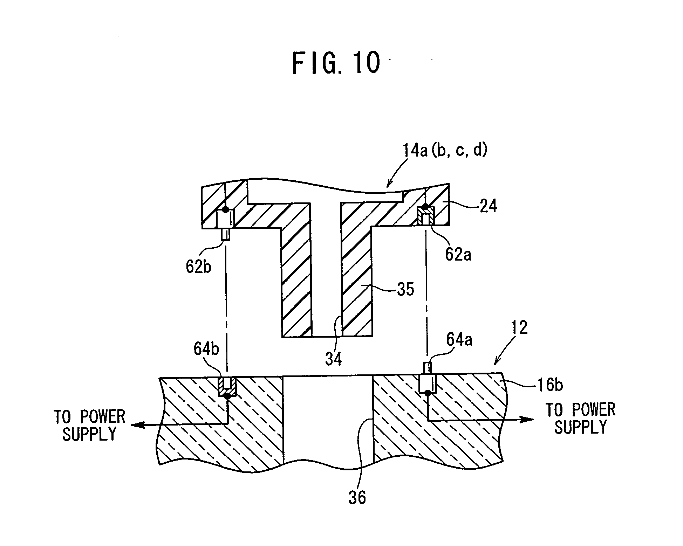

FIG. 10 is a perspective view showing fitting structures of plugs and sockets as first through fourth terminals shown in FIG. 7;

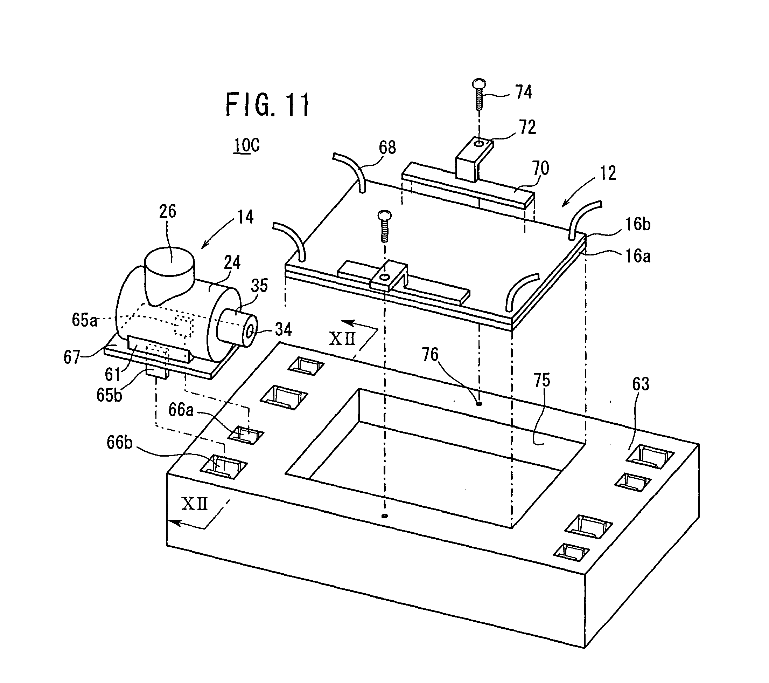

FIG. 11 is an exploded perspective view of an electroosmotic pump system according to a third embodiment;

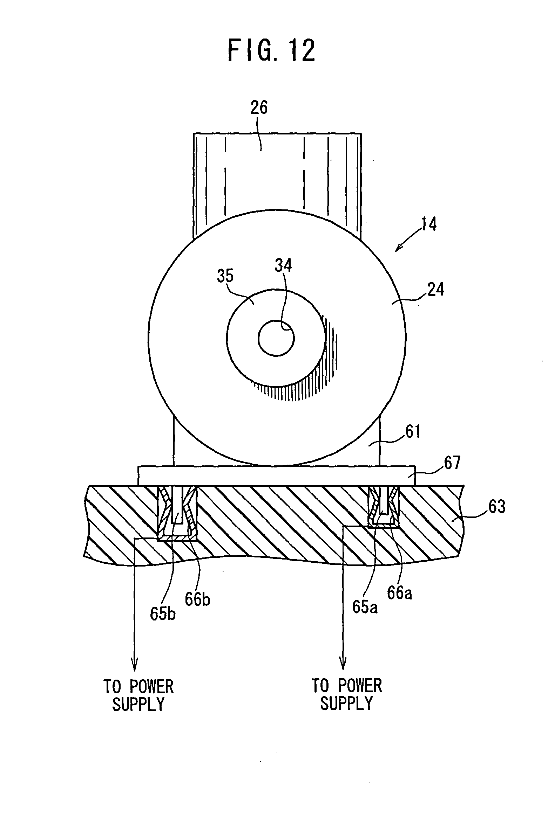

FIG. 12 is a cross-sectional view taken along line XII - XII of FIG. 11;

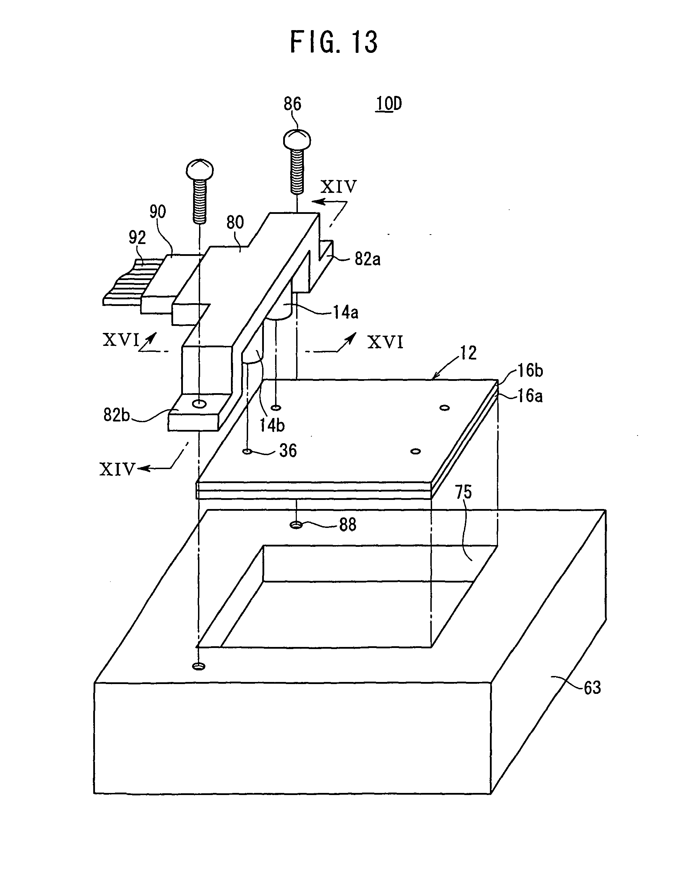

FIG. 13 is an exploded perspective view of an electroosmotic pump system according to a fourth embodiment;

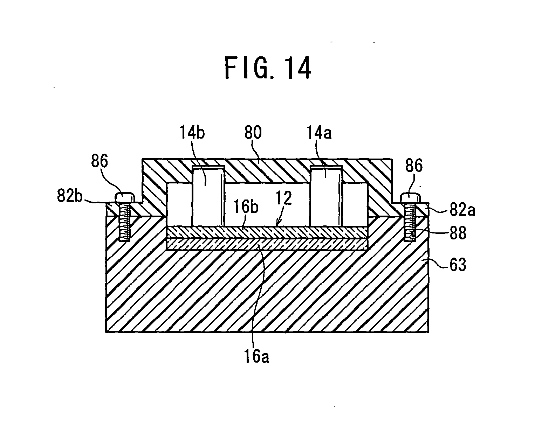

FIG. 14 is a cross-sectional view taken along line XIV - XIV of FIG. 13;

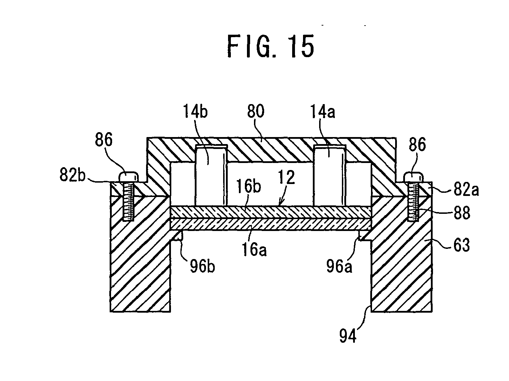

FIG. 15 is a cross-sectional view showing a hole defined centrally in a holder member shown in FIG. 14;

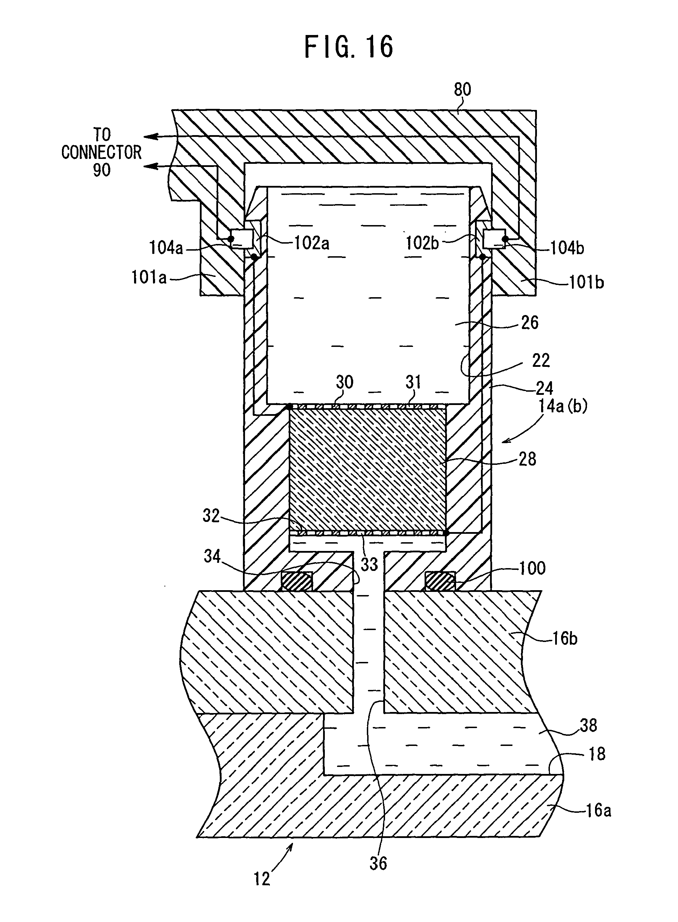

FIG. 16 is a cross-sectional view taken along line XVI - XVI of FIG. 13;

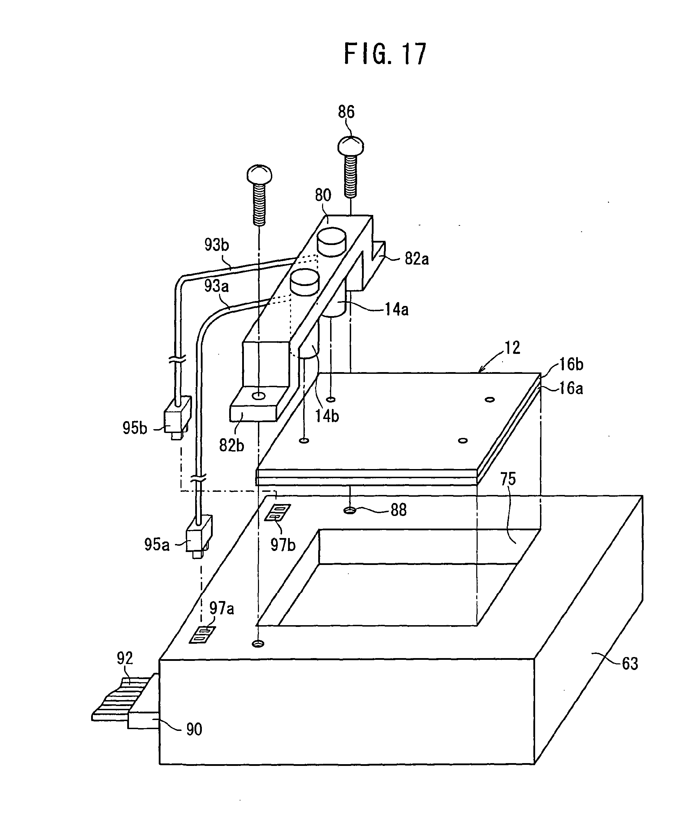

FIG. 17 is a perspective view showing the manner in which plugs of cables extending from a connector are electrically connected to sockets of the holder;

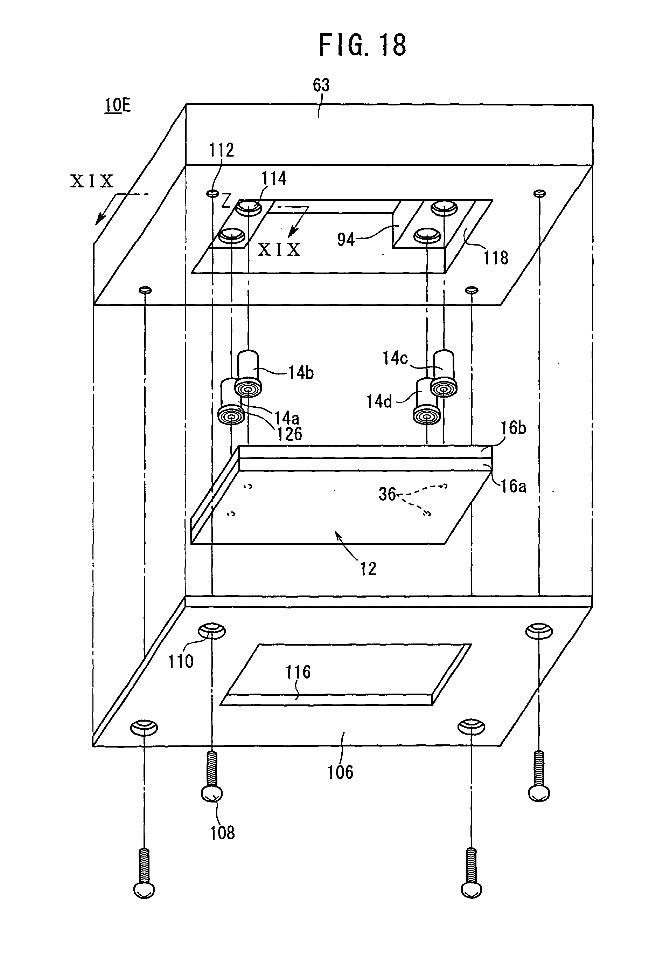

FIG. 18 is an exploded perspective view of an electroosmotic pump system according to a fifth embodiment;

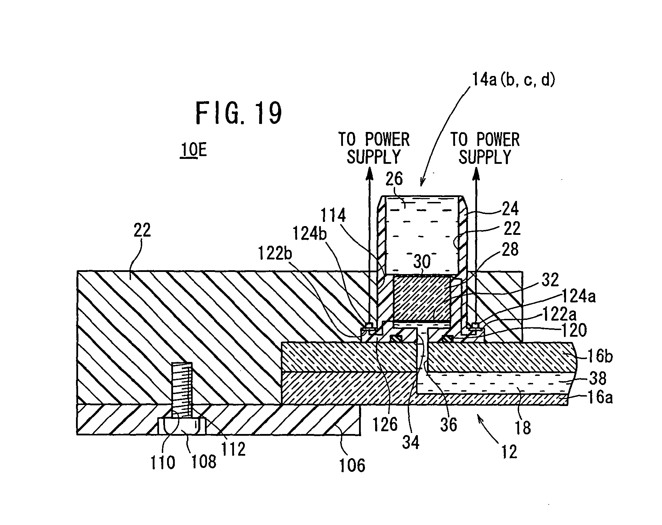

FIG. 19 is a cross-sectional view taken along line XIX - XIX of FIG. 18;

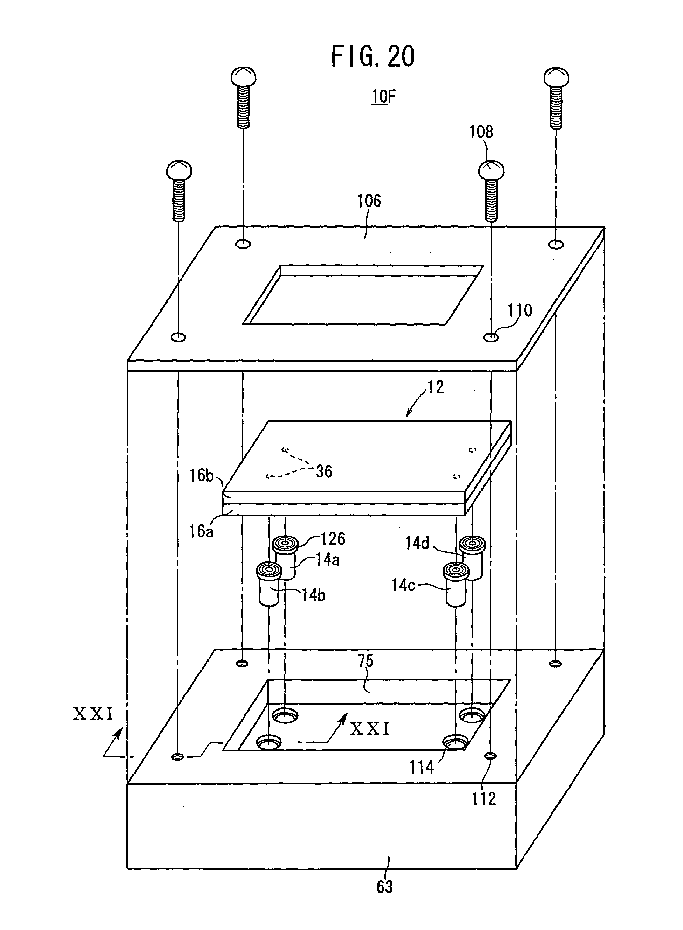

FIG. 20 is an exploded perspective view of an electroosmotic pump system according to a sixth embodiment;

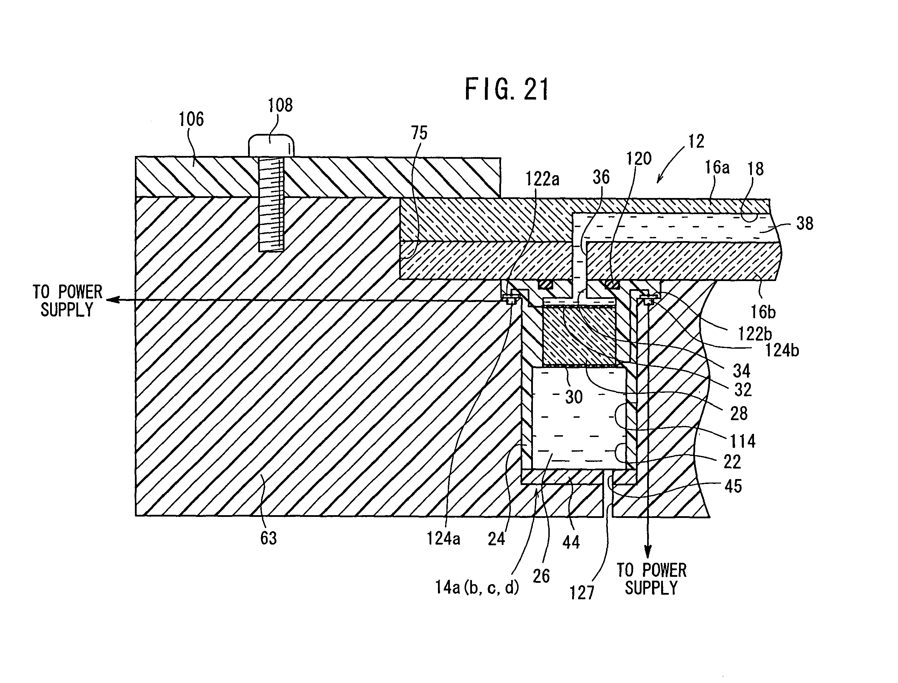

FIG. 21 is a cross-sectional view taken along line XXI - XXI of FIG. 20;

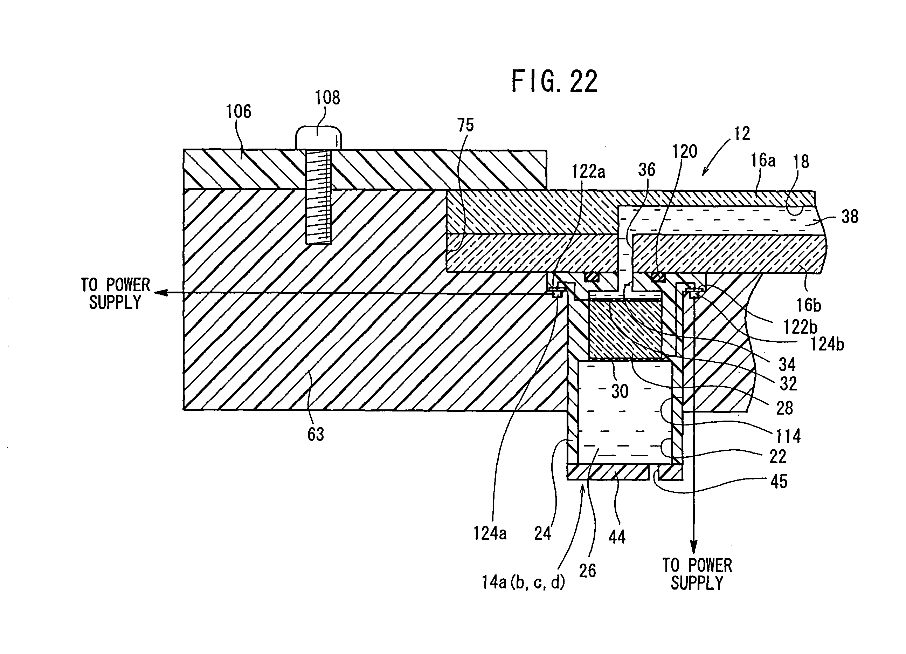

FIG. 22 is a cross-sectional view showing the manner in which a lid side of the electroosmotic pump projects from the lower surface of a holder member;

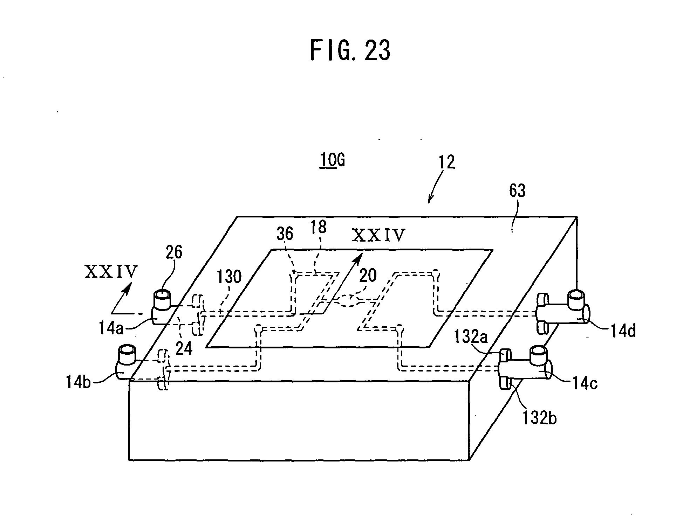

FIG. 23 is a perspective view of an electroosmotic pump system according to an eighth embodiment;

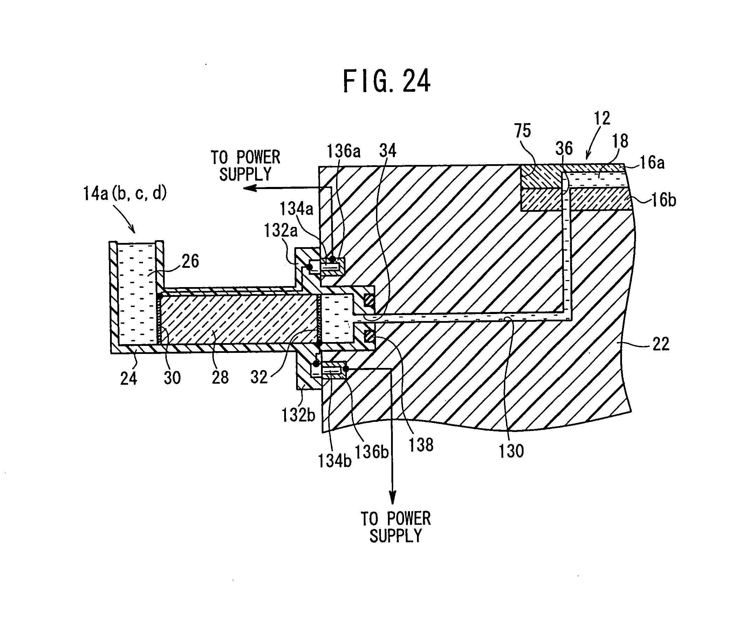

FIG. 24 is a cross-sectional view taken along line XXIV - XXIV of FIG. 23;

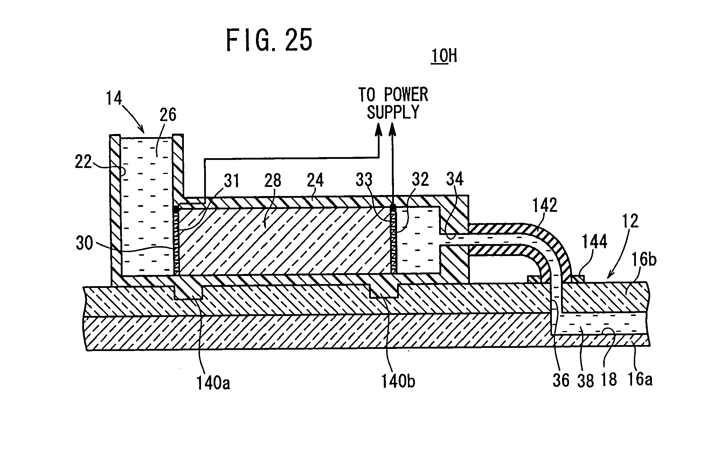

FIG. 25 is a cross-sectional view of an electroosmotic pump system according to an eighth embodiment;

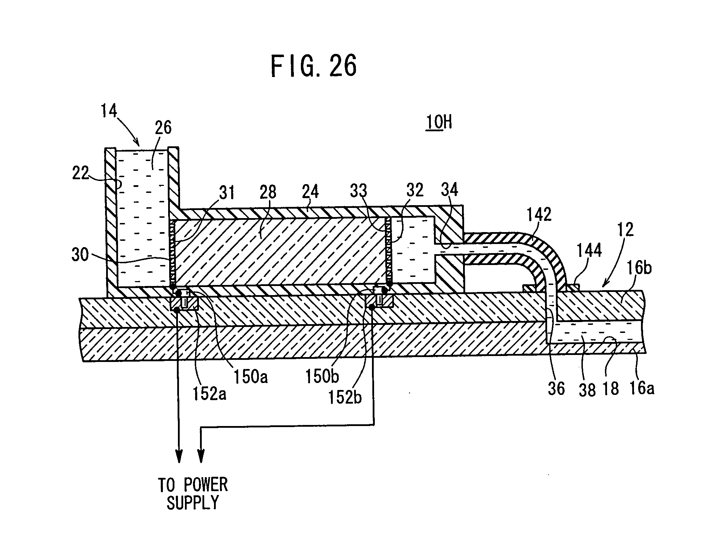

FIG. 26 is a cross-sectional view showing a modification of protrusions shown in FIG. 25;

FIG. 27 is a perspective view of essential components of a conventional pump system which employs a first method;

FIG. 28 is a cross-sectional view taken along line XXVIII - XXVIII of FIG. 27;

FIG. 29 is a perspective view of a packaged microfluidic chip;

FIG. 30 is a cross-sectional view taken along line XXX - XXX of FIG. 29;

FIG. 31 is an exploded perspective view of a conventional electroosmotic pump system; and

FIG. 32 is a cross-sectional view of a conventional pump system employing a diaphragm pump.

BEST MODE FOR CARRYING OUT THE INVENTION

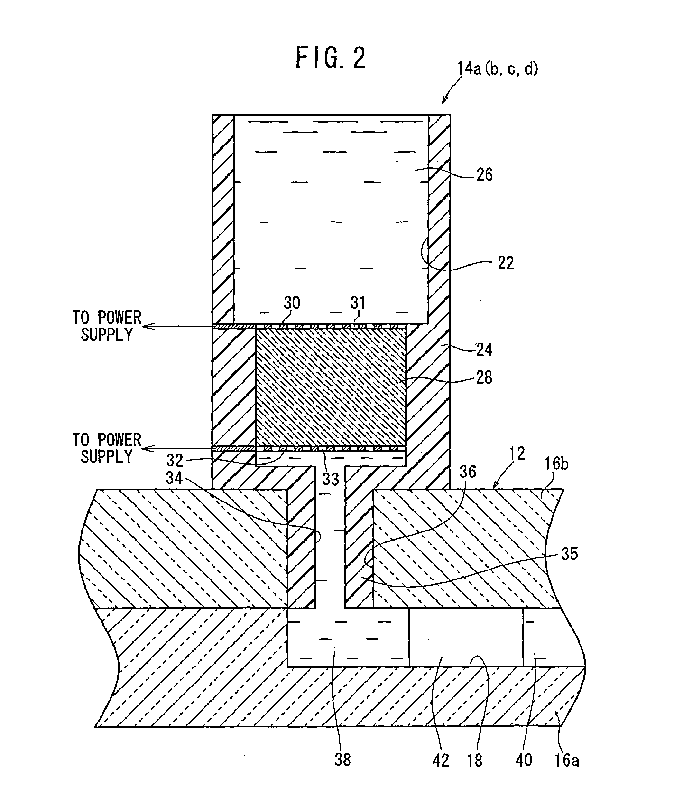

As shown in FIGS. 1 and 2, an electroosmotic pump system 10A according to a first embodiment comprises four electroosmotic pumps 14a through 14d directly mounted on an upper surface of a microfluidic chip 12.

The microfluidic chip 12 is of a size of about 10 [cm] $\times$ 5 [cm] $\times$ 2 [mm], and comprises glass substrates 16a, 16b whose respective upper and lower surfaces are bonded or thermally fused to each other. The glass substrate 16a has a groove of predetermined shape defined in the upper surface thereof. The glass substrate 16b has holes defined therein in facing relation to the opposite ends of the groove. When the glass substrate 16a and the glass substrate 16b are joined to each other, the groove, the lower surface of the glass substrate 16b, and the holes jointly make up a second fluid passage 18. The holes serve as communication holes 36 of the second fluid passage 18 which communicate with the electroosmotic pumps 14a through 14d. As shown in FIG. 1, a reactor 20 which is part of the groove and is coupled to the second fluid passage 18 is formed centrally in the microfluidic chip 12.

In the present embodiment, the glass substrates 16a, 16b make up the microfluidic chip 12. However, plastic substrates or silicon substrates may make up the microfluidic chip 12.

Each of the electroosmotic pumps 14a through 14d is of a size of about 10 [mm] or less. As shown in FIGS. 1 and 2, a hollow cylindrical pump casing 24 has a first fluid passage 22 defined therein for supplying a drive liquid 38 to or drawing a drive liquid 38 from the second fluid passage 18. The first fluid passage 22 accommodates therein a first electrode 30 having a plurality of holes 31 defined therein, an electroosmotic member 28, and a second electrode 32 having a plurality of holes 33 defined therein. The first electrode 30, the electroosmotic member 28, and the second electrode 32 are arranged in the order named along the axial direction of the first fluid passage 22.

In each of the electroosmotic pumps 14a through 14d, the first electrode 30 is disposed upstream of the electroosmotic member 28, and the second electrode 32 is disposed downstream of the electroosmotic member 28.

A portion of the first fluid passage 22 which extends upstream of the first electrode 30 serves as a liquid reservoir (reservoir) 26 for being filled with the liquid 38 from an external source. Each of the electroosmotic pumps 14a through 14d has a boss 35 on a downstream outer peripheral surface thereof, the boss 35 projecting toward the microfluidic chip 12 and fitted in the communication hole 36. The boss 35 has a discharge port 34 defined therein along the axial direction of the first fluid passage 22 for discharging the liquid 38.

The pump casing 24 is made of a plastic material that is resistant to the liquid 38 such as an electrolytic solution or the like which passes through the first fluid passage 22, or ceramic, glass, or a metal material whose surface is electrically insulated.

The electroosmotic member 28 is made of silica, alumina, zirconia, an oxide such as $TiO_2$ or the like, or a polymeric material. The electroosmotic member 28 is shaped as a porous body made of sintered ceramics or a polymeric material, or shaped as fibers, or shaped from a filled powder of any of the above materials. If the electroosmotic member 28 is shaped as a porous body or is of a filled structure, then it has a pore diameter ranging from several tens [nm] to several [μm].

The electrodes 30, 32 are made of an electrically conductive material such as platinum, silver, carbon, stainless steel, or the like. The electrodes 30, 32 may be shaped as a porous body as shown in FIG. 2, or wires, meshes, sheets, or layers of an electrically conductive material which are evaporated on the upstream and downstream surfaces of the electroosmotic member 28. The electrodes 30, 32 are electrically connected to a power supply, not shown.

An example of the size of each of the electroosmotic pumps 14a through 14d will be described below.

Each of the electroosmotic pumps 14a through 14d has an overall length of 13 [mm]. The pump casing 24 has an overall length of 11 [mm], and the boss 35 has an overall length of 2 [mm]. The pump casing 24 has an outside diameter of 6 [mm], and the boss 35 has an outside diameter of 2 [mm]. The liquid reservoir 26 has an inside diameter of 4 [mm], and the discharge port 34 has a diameter of 0.5 [mm].

In each of the electroosmotic pumps 14a through 14d, the electroosmotic member 28 has an overall length of 3 [mm] and an outside diameter of 3 [mm]. If the electroosmotic member 28 is porous, then it has a pore diameter ranging from several tens [nm] to several [$\mu$m].

The above size is given by way of example only, and may be changed depending on the specifications of the electroosmotic pump system 10A.

The electroosmotic pump system 10A according to the first embodiment is constructed as described above. Operation of the electroosmotic pump system 10A will be described below with reference to FIGS. 1 through 3.

A process of actuating the electroosmotic pumps 14a through 14d to control the position of a liquid 40 in the second fluid passage 18 with the electroosmotic pumps 14a through 14d being directly mounted on the microfluidic chip 12 will be described below.

It is assumed that the second fluid passage 18 is supplied with the liquid 40 in advance and the liquid 40 is to be driven by the electroosmotic pumps 14a through 14d.

First, the bosses 35 of the electroosmotic pumps 14a through 14d are fitted respectively into the communication holes 36 in the microfluidic chip 12. The first fluid passages 22 are held in fluid communication with the second fluid passage 18 through the discharge ports 34, and a seal is provided between the microfluidic chip 12 and the electroosmotic pumps 14a through 14d, preventing the fluid from leaking out from between the first fluid passages 22 and the second fluid passage 18. The fluid includes the liquids 38, 40, a gas 42 which is present in the second fluid passage 18, and a gas which is present in the liquids 38, 40.

Then, the liquid 38 is supplied from an external source to the liquid reservoir 26 of each of the electroosmotic pumps 14a through 14d, filling the liquid reservoir 26 with the liquid 38. The liquid 38 supplied to the liquid reservoir 26 reaches the upstream surface (the first electrode 30 side) of the electroosmotic member 28 due to its own weight or a capillary effect. Even if no voltage is applied between the first electrode 30 and the second electrode 32, the liquid 38 that has reached the upstream surface of the electroosmotic member 28 penetrates the electroosmotic member 28 due to a capillary effect therein, and reaches the downstream surface (the second electrode 32 side) of the electroosmotic member 28.

Since the electroosmotic member 28 is in the form of a porous body having a plurality of minute pores, fibers, or a structural body filled with minute particles, when the surface of the electroosmotic member 28 on the first electrode 30 side is wet by the liquid 38, the electroosmotic member 28 automatically draws in the liquid 38, causes the liquid 38 to penetrate the electroosmotic member 28 until the liquid 38 wets the surface of the electroosmotic member 28 on the second electrode 32 side. In other words, if the liquid reservoir 26 is filled with the liquid 38, then the electroosmotic member 28 automatically draws in the liquid 38 based on its self-priming capability due to a capillary effect. Therefore, when a voltage V is applied between the first electrode 30 and the second electrode 32, the liquid 38 is driven by an electroosmotic action.

Then, when a voltage is applied between the first electrode 30 and the second electrode 32 by a power supply, not shown, the liquid 38 that has permeated through the electroosmotic member 28 and the liquid 38 in the liquid reservoir 26 move downstream based on the electroosmotic phenomenon, and are supplied through the discharge port 34 into the second fluid passage 18. Consequently, the liquid 38 is introduced into the second fluid passage 18 in the microfluidic chip 12. When the liquid 38 moves from the second electrode 32 toward the second fluid passage 18, the gas 42 in the second fluid passage 18 pushes the liquid 40 under the pushing force from the liquid 38, so that the liquid 40 can be moved to a desired position.

In the above description, the liquid 38 supplied from the electroosmotic pumps 14a through 14d to the second fluid passage 18 is moved to the right in the second fluid passage 18 to control the position of the liquid 40. If, on the other hand, the liquid 38 is to be moved to the left in the second fluid passage 18 and drawn from the second fluid passage 18 into the electroosmotic pumps 14a through 14d, then a voltage having the polarity opposite to the above voltage may be applied between the first electrode 30 and the second electrode 32.

In the above description, the liquid 38 is supplied to the liquid reservoir 26 after the electroosmotic pumps 14a through 14d and the microfluidic chip 12 have been assembled together. However, after the liquid reservoir 26 has been filled with the liquid 38, the electroosmotic pumps 14a through 14d may be directly mounted on the microfluidic chip 12.

In the above description, furthermore, the second fluid passage 18 is filled with the liquid 40 before the electroosmotic pumps 14a through 14d are directly mounted on the microfluidic chip 12. However, if the liquid 40 is a liquid capable of producing an electroosmotic phenomenon, then one of the electroosmotic pumps 14a through 14d may be filled with the liquid 40, and the liquid 40 may be supplied from the electroosmotic pumps 14a through 14d to the second fluid passage 18.

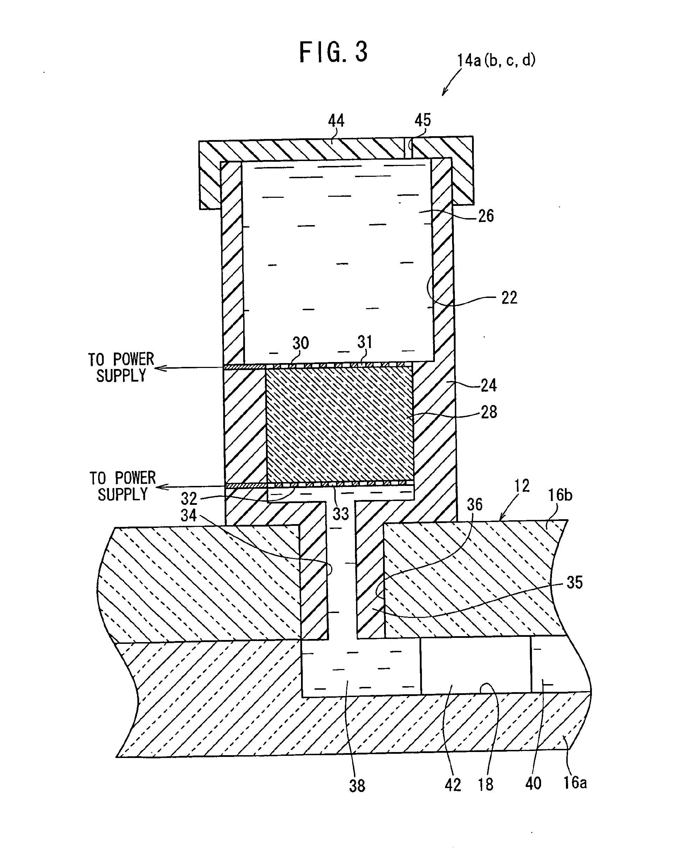

In the above description, furthermore, the liquid reservoir 26 has an upper portion that is open into the external space. However, as shown in FIG. 3, a lid 44 may be placed over the liquid reservoir 26 after the liquid reservoir 26 is filled with the liquid 38. The lid 44 is effective to prevent the liquid 38 from being evaporated from the liquid reservoir 26 and also to prevent dust from entering the liquid 38. The lid 44 has an air bleeder hole 45 defined therein for the liquid reservoir 26.

In the above description, furthermore, the bosses 35 are fitted respectively in the communication holes 36 to provide a seal between the electroosmotic pumps 14a through 14d and the microfluidic chip 12. However, a seal may be provided between the electroosmotic pumps 14a through 14d and the microfluidic chip 12 by, for example, (1) a process of forcibly fixing the electroosmotic pumps 14a through 14d and the microfluidic chip 12 to each other with screws, nails, or the like, (2) a process of joining the electroosmotic pumps 14a through 14d and the microfluidic chip 12 to each other with an adhesive or a tackiness agent, (3) a process of making the bosses 35 and regions around the communication holes 36 of a magnetic material and holding the electroosmotic pumps 14a through 14d and the microfluidic chip 12 together under magnetic forces, or (4) a process of inserting the pump casing 24 into a holder and connecting the holder to the microfluidic chip 12. These processes may be employed in combination.

If the above processes (1) through (4) are employed to provide the fitting structure of the bosses 35 and the communication holes 36, it is possible to provide a more reliable seal between the electroosmotic pumps 14a through 14d and the microfluidic chip 12.

In the above description, furthermore, the liquid reservoir 26 is integrally combined with the pump casing 24. Alternatively, the liquid reservoir 26 may be separate from the pump casing 24 and may be connected thereto by a tube, not shown. When the liquid 38 is supplied from the liquid reservoir 26 to the pump casing 24 by a capillary effect, since the level of the liquid 38 in the liquid reservoir 26 does not need to be positioned above the electroosmotic member 28, the level of the liquid 38 may be positioned downstream of the electroosmotic member 28 (between the second electrode 32 and the discharge port 34).

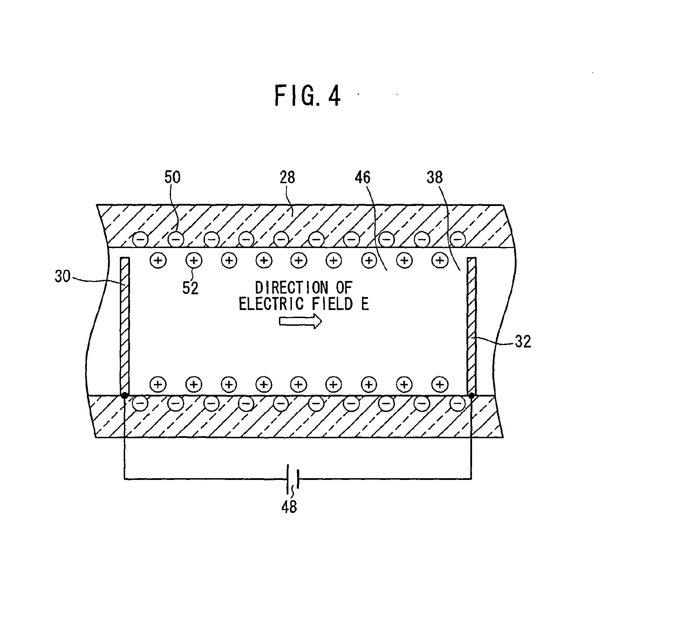

FIG. 4 is an enlarged cross-sectional view illustrative of how the liquid 38 operates in the electroosmotic member 28. The liquid 38 as it passes in a pore 46 in the electroosmotic member 28 from the first electrode 30 toward the second electrode 32 will be described below. In FIG. 4, for an easier explanation of the operation of the liquid 38, it is assumed that the first electrode 30 is a straight electrode disposed upstream of the pore 46 and the second electrode 32 is a straight electrode disposed downstream of the pore 46.

When the liquid 38 and the electroosmotic member 28 which is solid are held in contact with each other, ions are produced in a chemical reaction by the contact between the liquid 38 and the electroosmotic member 28 in the vicinity of the contacting surfaces. The electroosmotic pumps 14a through 14d drive the produced ions by an electric field.

For example, if the electroosmotic member 28 comprises a porous body in the form of a fine tube of fused quartz and the liquid 38 is water, then a silanol group (SiOH) 50 is generated in the surface of the fused quartz which contacts the water in the fine tube, and is ionized and charged negatively at a portion having high pH values. In the water, protons ($H^+$) 52 are generated as positive ions.

When a positive voltage is applied from a DC power supply 48 to the first electrode 30 and a negative voltage is applied from the DC power supply 48 to the second electrode 32, an electric field E is generated which is directed from the first electrode 30 to the second electrode 32. Though a force directed toward the first electrode 30 acts on the silanol group 50, the silanol group 50 cannot move toward the first electrode 30 as it is ions in the fused quartz.

On the other hand, a force directed toward the second electrode 32 acts on the protons 52 which are positive ions in the liquid 38. As a result, the protons 52 are moved toward the second electrode 32 under the force. If the liquid 38 comprises an electrolyte having an ion intensity of about 1 [mM], then the protons 52 are present in a very thin region of about 10 [nm] from the surface contacting the fused quartz. Therefore, the action of the force generated toward the second electrode 32 under the electric field E is limited to the very thin region along the surface of the liquid 38 which contacts the fused quartz.

However, the liquid 38 that is present in a region which is free of the force under the electric field E also moves along the direction of the electric field E due to the viscosity of the liquid 38. Thus, the liquid 38 in the fine tube can be driven. As a result, it is possible to supply the liquid 38 that has permeated in the electroosmotic member 28 and the liquid 38 which has filled the liquid reservoir 26 (see FIG. 2), from the second electrode 32 through the discharge port 34 to the second fluid passage 18.

The performance of the electroosmotic pumps 14a through 14b will be described below with reference to FIGS. 1 through 5B.

For fabricating the electroosmotic pumps 14a through 14d, it is preferable that the electroosmotic member 28 be made of an electroosmotic material which provides a large zeta potential $\zeta$ with respect to the drive liquid 38 and that the electroosmotic member 28 has a plurality of minute-diameter fluid passages defined therein.

The achievement of a desired pump performance level for the electroosmotic pumps 14a through 14d which are of a size of about several [mm] will be described below based on the calculation of a flow rate F and a pressure P of the electroosmotic pumps 14a through 14d with a simplified structure of the electroosmotic member 28.

First, it is assumed that the electroosmotic member 28 comprises a porous body having a plurality of parallel pores 46 extending from the first electrode 30 to the second electrode 32. When the liquid 38 from the liquid reservoir 26 permeates in the electroosmotic member 28 and fills the pores 46, the wall surfaces of the pores 46 are charged, developing a zeta potential $\zeta$. Based on the dielectric constant $\varepsilon$ and the viscosity $\mu$ of the liquid 38, the voltage V applied between the first electrode 30 and the second electrode 32, the distance L between the first electrode 30 and the second electrode 32, and the sum A of the cross-sectional areas of the pores 46 (hereinafter referred to as "effective fluid passage area A"), the flow rate F of the electroosmotic pumps 14a through 14d is expressed by the following equation (1):

$$F = A\varepsilon\zeta V/(\mu L) \qquad\qquad (1)$$

The flow rate F represents a flow rate when the back pressure is substantially 0.

If there is a back pressure in the pores 46, then the flow rate F is determined by the superposition of a reverse flow of the liquid 38 due to the pressure gradient and a flow of the liquid 38 due to an electroosmotic phenomenon. The pressure developed when the net flow rate F becomes substantially 0 due to a balance between the two flows represents the pressure P of the electroosmotic pumps 14a through 14d.

If the diameter of each of the pores 46 of the electroosmotic member 28 (hereinafter referred to as "effective fluid passage diameter") is represented by "a", then the pressure P is expressed by the following equation (2):

$$P = 8\varepsilon\zeta V/a^2 \qquad\qquad (2)$$

For designing the electroosmotic pumps 14a through 14d, if the physical and chemical properties of the liquid 38 are already known, then the pressure P of the electroosmotic pumps 14a through 14d is determined from the type and shape (the effective fluid passage diameter a) of the electroosmotic material of the electroosmotic member 28 and the voltage V according to the equation (2), and the flow rate F is determined from the effective fluid passage area A and the electric field intensity V/L according to the equation (1).

FIG. 5A is a graph showing the relationship between the voltage V and the flow rate F of the electroosmotic pumps 14a through 14d, and FIG. 5B is a graph showing the relationship between the maximum pressure P and the flow rate F of the electroosmotic pumps 14a through 14d. In FIGS. 5A and 5B, solid dots (symbols "•") represent measured values, and straight lines represent regression curves for the measured values according to the method of least squares.

The graphs shown in FIGS. 5A and 5B were plotted when the liquid 38 was a borate standard buffer solution (10 % diluted solution). The graph shown in FIG. 5B was plotted at V = 15 [v]. The electroosmotic member 28 was in the form of a sintered body having a diameter of 3 [mm] and an overall length of 3 [mm], the sintered body being produced by sintering spherical silica particles having a particle diameter of about 1 [$\mu$m] at a packing ratio ranging from 75 [%] to 80 [%].

The results shown in FIGS. 5A and 5B indicate that 6 [kPa/V] was obtained as the pressure characteristics and 0.2 [$\mu$l/(min·V·mm)] as the flow rate characteristics (the flow rate per unit electric field and unit cross-sectional area). It is clear from these numerical values that it is possible to realize the electroosmotic pumps 14a through 14d in a size of 10 [mm] or less for a voltage V up to 100 [V], a flow rate F in the range from several [nl/min] to several hundreds [$\mu$l/min], and a maximum pressure P in the range from several tens [kPa] to several hundreds [kPa].

The pump performance of the electroosmotic pumps 14a through 14d has been described above.

As described above, when the electroosmotic pumps 14a through 14d are mounted on the microfluidic chip 12 and the bosses 35 are fitted in the communication holes 36, the electroosmotic pumps 14a through 14d are secured to the microfluidic chip 12 with a seal provided therebetween. As a result, the liquid 38 can be supplied to the second fluid passage 18 (see FIG. 2).

Compared with the conventional arrangements shown in FIGS. 27 through 30, the electroosmotic pump system 10A according to the first embodiment (see FIGS. 1 through 4, 6) is free of the dead space corresponding to the fluid passage 208 shown in FIGS. 27 through 30. With respect to the conventional arrangements, the problems caused by the dead space have been pointed out. According to the present embodiment shown in FIGS. 1 through 4, 6, the dead space is limited only to the fluid inlet (the space of the communication hole 36 in the second fluid passage 18) for the liquid 38 in the microfluidic chip 12.

The effect that the dead space has on the movement of the liquid 40 based on the transmission of the pressure through the gas 42 such as air or the like in the second fluid passage 18 in the microfluidic chip 12 will quantitatively be described below.

In FIG. 2, for controlling the position of the liquid 40 in the second fluid passage 18 with the electroosmotic pumps 14a through 14d, the electroosmotic pumps 14a through 14d drives the liquid 38 into the fluid inlet, and the pressure of the gas 42 increases, moving the liquid 40 under the increased pressure.

For moving the liquid 40, a threshold pressure exists for producing an initial movement thereof. When the pressure applied through the gas 42 to the liquid 40 exceeds the threshold pressure, the liquid 40 starts moving in the second fluid passage 18. Once the liquid 40 has moved, the pressure required to move the liquid 40 subsequently is lower than the threshold pressure. Therefore, even when the pressurization by the electroosmotic pumps 14a through 14d is stopped, the liquid 40 is not released of the pressure and continues to move.

If the volume of the gas 42 between the drive liquid 38 and the liquid 40 is represented by v, the cross-sectional area of the second fluid passage 18 by S, the initial gas pressure by P0, the pressure required for the liquid 40 to start moving by P1, the pressure when the liquid 40 stops moving by P2 (P2 < P1), the distance (positional accuracy) that the liquid 40 moves after the pressurization is stopped by $\Delta$x, and the volume of the gas 42 which corresponds to the positional accuracy by $\Delta$v, then the positional accuracy $\Delta$x is expressed according to the following equation (3):

$$\Delta x \;=\; \Delta v/S \;=\; (v/S)(P1 - P2)/P0 \qquad (3)$$

For example, if v = 1 [$\mu$l], P0 = 100 [kPa], (P1 - P2) = 100 [Pa], and S = 100 [$\mu$m] $\times$ 50 [$\mu$m], then $\Delta$v = 1 [nl] and Ax = 0.2 [mm]. Thus, the liquid 40 in the second fluid passage 18 can be handled with an accuracy of about 1 [nl]. The magnitudes of the positional accuracy $\Delta$x and the volume $\Delta$v are related to the size of the dead space referred to above. The controllability of the liquid 40 can be increased by reducing the dead space.

More specifically, if the volume v of the space (the gas 42) from the discharge port 34 to the second fluid passage 18 is 10 [nl] < v < 10 [$\mu$l] or the distance from the discharge port 34 to the second fluid passage 18 ranges from 5 [$\mu$m] to 50 [mm], then the dead space is of a numerical value smaller than the fluid inventory in the microfluidic chip 12. Therefore, such numerical values are more effective to improve the controllability of the liquid 40.

With the electroosmotic pump system 10A according to the first embodiment, as described above, the electroosmotic pumps 14a through 14d and the microfluidic chip 12 are separate from each other, and the electroosmotic pumps 14a through 14d are directly mounted on the microfluidic chip 12 by the bosses 35. Specifically, the electroosmotic pumps 14a through 14d and the microfluidic chip 12 are integrally combined with each other from the standpoint of reducing the size of the entire system. If the electroosmotic pumps 14a through 14d and the microfluidic chip 12 are general-purpose products, then the entire system can be constructed at a low cost. Stated otherwise, the small-size electroosmotic pumps 14a through 14d are disposed more closely to the microfluidic chip 12 than with the conventional arrangements. As a result, the entire system can be reduced in size for increased system mobility. Since the electroosmotic pumps 14a through 14d are detachably mounted on the microfluidic chip 12, the general versatility is increased and the entire system is low in cost.

Because the electroosmotic pumps 14a through 14d are directly mounted on the microfluidic chip 12, the tubes employed in the conventional arrangements are not required. As a result, the reagent is not wasted, and the minute amounts of gas 42 and liquid 40 in the second fluid passage 18 can be controlled with high accuracy. According to the present embodiment, therefore, more practical fluid control can be achieved at a lower cost than with the conventional arrangements.

Furthermore, the bosses 35 function as an interface for securing the electroosmotic pumps 14a through 14d to the microfluidic chip 12 and also as an interface for supplying and drawing in the fluid, such as the liquid 38, etc., between the electroosmotic pumps 14a through 14d and the microfluidic chip 12. Consequently, the overall system arrangement is simplified.

When the bosses 35 are fitted in the communication holes 36 of the second fluid passage 18, the first fluid passages 22 are held in fluid communication with the second fluid passage 18 through the discharge ports 34, and the electroosmotic pumps 14a through 14d are directly mounted on the microfluidic chip 12. Consequently, simply when the bosses 35 are fitted in the second fluid passage 18, an efficient seal is provided between the electroosmotic pumps 14a through 14d and the microfluidic chip 12, reliably allowing the fluid to be supplied from the electroosmotic pumps 14a through 14d to the microfluidic chip 12 and to be drawn from the microfluidic chip 12 into the electroosmotic pumps 14a through 14d.

The liquid 38 supplied to the liquid reservoir 26 reaches the end of the electroosmotic member 28 on the first electrode 30 side due to its own weight or a capillary effect. Even if the voltage V is not applied between the first electrode 30 and the second electrode 32, the liquid 38 that has reached the end of the electroosmotic member 28 penetrates the electroosmotic member 28 due to a capillary effect therein, and reaches the end of the electroosmotic member 28 on the second electrode 32 side. Therefore, with the liquid reservoir 26 being filled with the liquid 38 in advance, no liquid supply lines are needed for supplying the liquid from an external source to the electroosmotic pumps 14a through 14d. The mobility of the entire system is thus further increased.

Use of the electroosmotic pumps 14a through 14d makes it possible to drive the liquid 38 under a voltage ranging from 10 [V] to 30 [V] from a DC power supply, unlike the conventional arrangements. Consequently, the liquid 38 can be driven under a low drive voltage, and a battery may be used as the DC power supply.

Use of the electroosmotic pumps 14a through 14d is also effective to drive the liquid 38 as a pulsation-free flow. The positional accuracy $\Delta x$ of the liquid 40 can thus be further reduced.

In the above description, the bosses 35 are provided on the outer peripheral surfaces of the electroosmotic pumps 14a through 14d, and are fitted in the communication holes 36. Instead of such a structure, as shown in FIG. 6, bosses 17 may be disposed on the upper surface of the glass substrate 16b with the communication holes 36 being defined in the bosses 17, and the discharge ports 34 in the electroosmotic pumps 14a through 14d, rather than the bosses 35 (see FIG. 2), may have a diameter which is substantially the same as the outside diameter of the bosses 17. When the bosses 17 are fitted in the discharge ports 34, the first fluid passages 22 are held in fluid communication with the second fluid passage 18 through the discharge ports 34, and a seal is provided between the microfluidic chip 12 and the electroosmotic pumps 14a through 14d, preventing the fluid from leaking out from between the first fluid passages 22 and the second fluid passage 18.

An electroosmotic pump system 10B according to a second embodiment will be described below with reference to FIG. 7. Those parts of the electroosmotic pump system 10B which are identical to those of the electroosmotic pump system 10A according to the first embodiment shown in FIGS. 1 through 6 are denoted by identical reference characters. This also applies to other embodiments.

As shown in FIG. 7, the electroosmotic pump system 10B according to the second embodiment differs from the electroosmotic pump system 10A according to the first embodiment (see FIGS. 1 through 6) in that it has a first terminal 54a electrically connected to the first electrode 30 and a second terminal 54b electrically connected to the second electrode 32, the first and second terminals 54a, 54b being disposed on the outer peripheral surface of the pump casing 24 on the boss 35 side, and a third terminal 56a and a fourth terminal 56b disposed on the upper surface of the glass substrate 16b of the microfluidic chip 12 in facing relation to the first terminal 54a and the second terminal 54b, respectively.

When the bosses 35 of the electroosmotic pumps 14a through 14d are fitted in the respective communication holes 36 in the microfluidic chip 12, the first fluid passage 22 is held in fluid communication with the second fluid passage 18 through the discharge ports 34, and a seal is provided between the microfluidic chip 12 and the electroosmotic pumps 14a through 14d, preventing the fluid from leaking out from between the first fluid passages 22 and the second fluid passage 18.

Inasmuch as the outer peripheral surface of the pump casing 24 on the boss 35 side is held in contact with the upper surface of the glass substrate 16b, the first terminal 54a and the third terminal 56a are electrically connected to each other, and the second terminal 54b and the fourth terminal 56b are electrically connected to each other. The third terminal 56a and the fourth terminal 56b are electrically connected to a power supply, not shown. Therefore, the power supply can apply a voltage of one polarity to the first electrode 30 through the third terminal 56a and the first terminal 54a, and a voltage of the opposite polarity to the second electrode 32 through the fourth terminal 56b and the second terminal 54b.

FIG. 8 shows spiral springs used as a first terminal 58a and a second terminal 58b. When the bosses 35 are fitted in the communication holes 36 and the outer peripheral surface of the pump casing 24 on the boss 35 side is held in contact with the upper surface of the glass substrate 16b, the first terminal 58a presses the third terminal 56a, and the second terminal 58b presses the fourth terminal 56b for reliable electrical connection therebetween.

FIG. 9 shows leaf springs used as a first terminal 60a and a second terminal 60b. When the bosses 35 are fitted in the communication holes 36 and the outer peripheral surface of the pump casing 24 on the boss 35 side is held in contact with the upper surface of the glass substrate 16b, the first terminal 60a presses the third terminal 56a, and the second terminal 60b presses the fourth terminal 56b for reliable electrical connection therebetween.

FIG. 10 shows sockets used as a first terminal 62a and a fourth terminal 64b and plugs as a second terminal 62b and a third terminal 64a. When the bosses 35 are fitted in the communication holes 36 and the outer peripheral surface of the pump casing 24 on the boss 35 side is held in contact with the upper surface of the glass substrate 16b, the first terminal 62a and the third terminal 64a are held in fitting engagement with each other, and the second terminal 62b and the fourth terminal 64b are held in fitting engagement with each other for reliable electrical connection therebetween. In addition, the electroosmotic pumps 14a through 14d are reliably secured to the microfluidic chip 12 in cooperation with the fitting engagement between the bosses 35 and the communication holes 36.

With the structure shown in FIG. 10, the first terminal 62a and the fourth terminal 64b are in the form of sockets and the second terminal 62b and the third terminal 64a are in the form of plugs. Therefore, the first terminal 62a and the fourth terminal 64b are prevented from being electrically connected to each other due to a misunderstanding of the power supply polarities, and the second terminal 62b and the third terminal 64a are prevented from being electrically connected to each other due to a misunderstanding of the power supply polarities. In other words, the sockets and the plugs are disposed in staggered relationship to prevent the polarities from being misunderstood when the electroosmotic pumps 14a through 14d are connected to the microfluidic chip 12. However, if no problem arises from a misunderstanding of the polarities, then plugs (or sockets) may be provided on the electroosmotic pumps 14a through 14d, and sockets (or plugs) may be provided on the microfluidic chip 12.

With the electroosmotic pump system 10B according to the second embodiment, as described above, when the electroosmotic pumps 14a through 14d are directly mounted on the microfluidic chip 12 through the bosses 35, the third terminal 56a, 64a is electrically connected to the first electrode 30 through the first terminal 54a, 58a through 62a, and the fourth terminal 56b, 64b is electrically connected to the second electrode 32 through the second terminal 54b, 58b through 62b. If the third terminal 56a, 64a and the fourth terminal 56b, 64b are electrically connected to an external power supply, then the power supply can apply a voltage of one polarity to the first electrode 30 through the third terminal 56a, 64a and the first terminal 54a, 58a through 62a and a voltage of the opposite polarity to the second electrode 32 through the fourth terminal 56b, 64b and the second terminal 54b, 58b through 62b, thereby actuating the electroosmotic pumps 14a through 14d. Therefore, the bosses 35 function as an interface for securing the electroosmotic pumps 14a through 14d to the microfluidic chip 12 and also as an interface for supplying and drawing in the fluid between the electroosmotic pumps 14a through 14d and the microfluidic chip 12. The first terminal 54a through 60a and the second terminal 54b through 60b function as an interface for supplying electric power. Moreover, the first terminal 62a and the second terminal 62b function as an interface for supplying electric power and an interface for securing the electroosmotic pumps 14a through 14d to the microfluidic chip 12. Consequently, the entire system is simplified.

In the electroosmotic pump system 10B according to the second embodiment, the connection between the first terminal 54a, 58a, 60a, 62a and the third terminal 56a, 64a, and the connection between the second terminal 54b, 58b, 60b, 62b and the fourth terminal 56b, 64b may be changed from the above structures to (1) the connection between the terminals with magnets or (2) the joining of the terminals with soldering, for example.

An electroosmotic pump system 10C according to a third embodiment will be described below with reference to FIGS. 11 and 12.

As shown in FIGS. 11 and 12, the electroosmotic pump system 10C according to the third embodiment differs from the electroosmotic pump system 10A according to the first embodiment (see FIGS. 1 through 6) and the electroosmotic pump system 10B according to the second embodiment (see FIGS. 7 through 10) in that it has a microfluidic chip 12 held by a holder member 63 and an electroosmotic pump 14 secured to and held on the holder member 63 by a support member 67, a first terminal 65a, and a second terminal 65b.

The holder member 63 comprises a substantially rectangular block with a recess 75 defined centrally therein for accommodating the microfluidic chip 12 therein. Specifically, the holder member 63 is a packaging member used for mounting the microfluidic chip 12 in position. The holder member 63 serves to secure and protect the microfluidic chip 12 and functions as an interface for supplying and drawing in the fluid between the electroosmotic pump 14 and the microfluidic chip 12, an interface for supplying electric power, and an interface for a signal. The signal may be, for example, an output signal from a sensor, not shown, incorporated in the microfluidic chip 12.

The holder member 63 has a plurality of holes defined in an upper surface thereof, and socket-shaped third terminals 66a and fourth terminals 66b are disposed in the holes.

The electroosmotic pump 14 is disposed on a support member 67 by a support member 61. The support member 67 has plug-shaped first and second terminals 65a, 65b disposed on a lower surface thereof in confronting relation to corresponding ones of the third and fourth terminals 66a, 66b. The electroosmotic pump 14 is basically of the same structure as the electroosmotic pumps 14a through 14d (see FIGS. 2, 3, and 6), but differs therefrom in that the pump casing 24 and the boss 35 are disposed parallel to the upper surface of the microfluidic chip 12, and the liquid reservoir 26 is oriented in a direction perpendicular to the axial direction of the pump casing 24.

When the first terminal 65a is fitted in the third terminal 66a, the second terminal 65b in the fourth terminal 66b, and the lower surface of the support member 67 is held in contact with the upper surface of the holder member 63, the electroosmotic pump 14 is secured to and held by the holder member 63 through the first through fourth terminals 65a through 66b, the first terminal 65a and the third terminal 66a are electrically connected to each other, and the second terminal 65b and the fourth terminal 66b are electrically connected to each other.

With the structure shown in FIG. 11, the plug-shaped first and second terminals 65a, 65b are of different sizes, and the socket-shaped third and fourth terminals 66a, 66b are also of different sizes depending on the first and second terminals 65a, 65b. Consequently, the first terminal 65a and the fourth terminal 66b are prevented from being electrically connected to each other due to a misunderstanding of the power supply polarities, and the second terminal 65b and the third terminal 66a are prevented from being electrically connected to each other due to a misunderstanding of the power supply polarities. In other words, the sockets and the plugs differently sized to prevent the polarities from being misunderstood when the electroosmotic pumps 14a through 14d and the holder member 63 are connected to each other.

Since the first terminal 65a and the second terminal 65b are of different sizes and the third terminal 66a and the fourth terminal 66b are also of different sizes, when the electroosmotic pump 14 is secured to the holder member 63 by the support member 67 and the first through fourth terminals 65a through 66b, the discharge port 34 can be oriented in confronting relation to the direction of the microfluidic chip 12 at all times.

If no problem arises from a misunderstanding of the polarities, then the plugs may be of substantially the same size, and the sockets may be of substantially the same size.

The microfluidic chip 12 disposed on the bottom of the recess 75 is secured to and held on the holder member 63 by pressers 70. Each of the pressers 70 is a substantially rectangular member for pressing the upper surface of the glass substrate 16b. A substantially L-shaped finger 72 extends from a central portion of the presser 70 along the recess 75 and the upper surface of the holder member 63.

Specifically, two pressers 70 are disposed on the upper surface of the microfluidic chip 12 disposed in the recess 75. Screws 74 extending through the fingers 72 are threaded into holes 76 defined in the holder member 63, causing the pressers 70 to press the upper surface of the microfluidic chip 12. As a consequence, the microfluidic chip 12 is secured to and held by the holder member 63.

A plurality of tubes 68 are connected to the microfluidic chip 12. When one of the tubes 68 is connected to the discharge port 34 of the electroosmotic pump 14, the microfluidic chip 12 is held in fluid communication with the electroosmotic pump 14.

With the electroosmotic pump system 10C according to the third embodiment, as described above, the electroosmotic pump 14, the microfluidic chip 12, and the holder member 63 are separate from each other. The electroosmotic pump 14 is mounted on the holder member 63 by the support members 61, 67 and the first through fourth terminals 65a through 66b, and the microfluidic chip 12 is secured to and held on the holder member 63 by the pressers 70 and the screws 74.

Specifically, the electroosmotic pump 14, the microfluidic chip 12, and the holder member 63 are integrally combined with each other from the standpoint of reducing the size of the entire system. If the electroosmotic pump 14, the microfluidic chip 12, and the holder member 63 are general-purpose products, then the entire system can be constructed at a low cost. Stated otherwise, the small-size electroosmotic pump 14 is disposed more closely to the microfluidic chip 12 by the holder member 63 than with the conventional arrangements. As a result, the entire system can be reduced in size for increased system mobility. Since the microfluidic chip 12 and the electroosmotic pump 14 are detachably mounted on the holder member 63, the general versatility is increased and the entire system is low in cost.

Because the electroosmotic pump 14 is mounted on the holder member 63 which holds the microfluidic chip 12, the distance between the electroosmotic pump 14 and the microfluidic chip 12 is smaller than with the conventional arrangements. As a consequence, the amount of a reagent which is wasted in the microfluidic chip 12 is reduced, and the minute amount of a fluid which is present in the second fluid passage 18 can be controlled with high accuracy. According to the present embodiment, therefore, more practical fluid control can be achieved at a lower cost than with the conventional arrangements.

The support members 61, 67 and the first through fourth terminals 65a through 66b function as an interface for securing the electroosmotic pump 14 to the holder member 63, the first through fourth terminals 65a through 66b as an interface for supplying electric power to apply a voltage from a power supply, not shown, to the electroosmotic pump 14, and the discharge port 34 and the tubes 68 as an interface for supplying and drawing in the fluid between the electroosmotic pump 14 and the microfluidic chip 12. The overall system arrangement is thus simplified.

As described above, the first terminal 65a and the third terminal 66a are electrically connected to each other, and the second terminal 65b and the fourth terminal 66b are electrically connected to each other. It is thus possible to apply a voltage of one polarity from the power supply to the first electrode 30 through the third terminal 66a and the first terminal 65a and a voltage of the opposite polarity from the power supply to the second electrode 32 through the fourth terminal 66b and the second terminal 65b for actuating the electroosmotic pump 14.

An electroosmotic pump system 10D according to a fourth embodiment will be described below with reference to FIGS. 13 through 17.

As shown in FIGS. 13 through 17, the electroosmotic pump system 10D according to the fourth embodiment differs from the electroosmotic pump systems 10A through 10C according to the first through third embodiments (see FIGS. 1 through 12) in that it has electroosmotic pumps 14a, 14b directly mounted on the microfluidic chip 12 and secured to and held on the holder member 63 by a connector member (electric connector member) 80.

The electroosmotic pumps 14a, 14b according to the present embodiment are of essentially the same structure as the electroosmotic pumps 14a, 14b according to the first and second embodiments (see FIGS. 2, 3, and 7), except that no bosses 35 are disposed on the outer peripheral surfaces of the electroosmotic pumps 14a, 14b on the microfluidic chip 12 side, O-rings 100 surrounding the discharge ports 34 are disposed in spaced relationship to the discharge ports 34, and socket-shaped first and second terminals 102a, 102b are disposed on upper portions of the electroosmotic pumps 14a, 14b.

As shown in FIGS. 13 through 16, the connector member 80 comprises a plate-like member whose opposite ends shaped as substantially L-shaped legs 82a, 82b. The connector member 80 is secured to the holder member 63 by screws 86 extending through the legs 82a, 82b and threaded into holes 88 defined in the holder member 63. The plate-like portion of the connector member 80 holds the upper portions of the electroosmotic pumps 14a, 14b.

Specifically, arms 101a, 101b extend from the plate-like portion of the connector member 80 along each of the pump casings 24. A plug-shaped third terminal 104a is disposed on the arm 101a for fitting engagement in the first terminal 102a, and a plug-shaped fourth terminal 104b is disposed on the arm 101b for fitting engagement in the second terminal 102b.

The third terminal 104a and the fourth terminal 104b are electrically connected to respective cables 92 coupled to a connector 90 which is fitted in the connector member 80. The cables 92 are electrically connected to a power supply, not shown. The ends of the electroosmotic pumps 14a, 14b on the liquid reservoir 26 side (the upper portions in FIG. 15) are of a tapered shape.

The electroosmotic pumps 14a, 14b are inserted in a cavity formed by the plate-like portion of the connector member 80 and the arms 101a, 101b. When the tapered portions of the electroosmotic pumps 14a, 14b are displaced toward the plate-like portion, the first terminal 102a and the third terminal 104a are brought into fitting engagement with each other, and the second terminal 102b and the fourth terminal 104b are brought into fitting engagement with each other. As a result, the electroosmotic pumps 14a, 14b are secured to and held on the connector member 80, the first terminal 102a and the third terminal 104a are electrically connected to each other, and the second terminal 102b and the fourth terminal 104b are electrically connected to each other.

When the electroosmotic pumps 14a, 14b are secured to and held on the connector member 80, the outer peripheral surfaces of the electroosmotic pumps 14a, 14b on the discharge port 34 side project toward the microfluidic chip 12 beyond the outer peripheral surfaces of the legs 82a, 82b on the holder member 63 side (see FIG. 14). Therefore, when the connector member 80 is secured to and held on the holder member 63, the electroosmotic pumps 14a, 14b press the upper surface of the glass substrate 16b. As a result, the first fluid passage 22 and the second fluid passage 18 are brought into fluid communication with each other through the discharge port 34 and the communication hole 36, and the O-ring 100 are pressed against the upper surface of the glass substrate 16b, providing a seal between the electroosmotic pumps 14a, 14b and the glass substrate 16b.

If the central region of the plate-like portion of the connector member 80 is of a hinge structure, not shown, for allowing the arms 101a, 101b to be movable toward and away from the pump casing 24, then when the hinge is opened to move the arms 101a, 101b, the third terminal 104a, and the fourth terminal 104b away from the pump casing 24, the electroosmotic pumps 14a through 14d can easily be removed from the connector member 80.

For optically observing the reactor 20 and the second fluid passage 18 in the microfluidic chip 12 from outside of the electroosmotic pump system, it is preferable as shown in FIG. 15 to form a hole 94 centrally in the holder member 63 and have teeth 96a, 96b projecting from inner wall surfaces of the hole 94 to hold the bottom of the microfluidic chip 16.

With the electroosmotic pump system 10D according to the fourth embodiment, when the connector member 80 to which the electroosmotic pumps 14a, 14b are secured through the first through fourth terminals 102a through 104b is fixed to the holder member 63, the electroosmotic pumps 14a, 14b press the microfluidic chip 12, and the O-ring 100 provides a seal between the electroosmotic pumps 14a, 14b and the microfluidic chip 12. The O-ring 100 serves as an interface for supplying and drawing in the fluid between the electroosmotic pumps 14a, 14b and the microfluidic chip 12, and the first terminal 102a and the second terminal 102b serve as an interface for securing the electroosmotic pumps 14a, 14b to the holder member 63 through the connector member 80 and an interface for supplying electric power which is electrically connected to an external power supply through the third terminal 104a and the fourth terminal 104b. Therefore, the overall system is simplified.

In the above description, the connector 90 is electrically connected to the connector member 80. However, as shown in FIG. 17, plugs 95a, 95b may be mounted on the distal ends of cables 93a, 93b extending from the connector member 80, and may be electrically connected to sockets 97a, 97b mounted on the upper surface of the holder member 63. The connector 90 can be connected to the holder member 63, and the cable 92 is electrically connected to the sockets 97a, 97b.

An electroosmotic pump system 10E according to a fifth embodiment will be described below with reference to FIGS. 18 and 19.

As shown in FIGS. 18 and 19, the electroosmotic pump system 10E according to the fifth embodiment differs from the electroosmotic pump systems 10A through 10D according to the first through fourth embodiments (see FIGS. 1 through 17) in that the electroosmotic pumps 14a through 14d are housed in the holder member 63, the microfluidic chip 12 is housed in a recess 118 defined in the lower surface of the holder member 63, and the microfluidic chip 12 is secured and held in position by being sandwiched by the holder member 63 and a presser 106.

The electroosmotic pumps 14a through 14d according to the present embodiment are of substantially the same structure as the electroosmotic pumps 14a, 14b (see FIG. 16) according to the fourth embodiment, but differs therefrom in that flanges 126 project radially as to the pump casings 24 from the outer peripheral surfaces on the microfluidic chip 12 side, and a first terminal 122a and a second terminal 122b are disposed on each of the flanges 126.

The holder member 63 has a hole 94 defined therein in fluid communication with the recess 118, and a plurality of holes 114 for accommodating the electroosmotic pumps 14a through 14d respectively therein are defined in steps formed by the hole 94 and the recess 118. The holes 114 are of a stepped configuration complementary in shape to the electroosmotic pumps 14a through 14d, and have a third terminal 124a and a fourth terminal 124b in confronting relation to the first terminal 122a and the second terminal 122b, respectively.

When the electroosmotic pumps 14a through 14d are inserted into the holes 114 from the lower side of the holder member 63, the electroosmotic pumps 14a through 14d housed in the holes 114, and the portions of the electroosmotic pumps 14a through 14d on the liquid reservoir 26 side project upwardly from the holder member 63.

Then, the microfluidic chip 12 is inserted into the recess 118 from the lower side of the holder member 63, and a portion of the lower surface of the microfluidic chip 12 and the lower surface of the holder member 63 are covered with the presser 106. The presser 106 has a hole 116 defined centrally therein which is smaller than the lower surface of the microfluidic chip 12. Therefore, when the presser 106 is pressed against the lower surface of the microfluidic chip 12, the microfluidic chip 12 will not fall. The hole 116 is used as a window for optically observing the fluid in the second fluid passage 18 and the reactor 20 in the microfluidic chip 12 from outside of the electroosmotic pump system.

Then, screws 108 are inserted through holes 110 defined in the presser 106 and threaded into holes 112 defined in the holder member 63. The presser 106 presses the microfluidic chip 12 upwardly. The microfluidic chip 12 then presses the electroosmotic pumps 14a through 14d on the flange 126 side. An O-ring 120 provides a seal between the flange 126 and the glass substrate 16b. At the same time, the first terminal 122a and the third terminal 124a are electrically connected to each other, and the second terminal 122b and the fourth terminal 124b are electrically connected to each other.

With the electroosmotic pump system 10E according to the fifth embodiment, when the microfluidic chip 12 and the electroosmotic pumps 14a, 14b are pressed by the presser 106, the holder member 63 realizes an interface for securing the electroosmotic pumps 14a, 14b and the microfluidic chip 12 to each other, an interface for supplying electric power, and an interface for supplying the fluid to and drawing in the fluid from the microfluidic chip 12, as with the electroosmotic pump systems 10C, 10D according to the third and fourth embodiments (see FIGS. 11 through 17). Therefore, the overall system is further simplified.

An electroosmotic pump system 10F according to a sixth embodiment will be described below with reference to FIGS. 20 through 22.

As shown in FIGS. 20 through 22, the electroosmotic pump system 10F according to the sixth embodiment differs from the electroosmotic pump system 10E according to the fifth embodiment (see FIGS. 18 and 19) in that a recess 75 defined in the upper surface of the holder member 63 accommodates the microfluidic chip 12 therein.

The holes 114 are defined in fluid communication with the recess 75 on the upper side (the recess 75 side) of the holder member 63. The recess 75 has a depth such that when the microfluidic chip 12 is housed in the recess 75, the upper surface of the microfluidic chip 12 and the upper surface of the holder member 63 lie flush with each other.

As shown in FIG. 21, since the electroosmotic pumps 14a through 14d are accommodated in the holes 114 with the discharge ports 34 up, the liquid reservoir 26 is positioned on the bottom side of the holder member 63.

The liquid 38 in the liquid reservoir 26 does not leak into the hole 114 due to surface tension. Further, in order to prevent the liquid 38 from being evaporated and contaminated, the opening of the liquid reservoir 26 is covered with the lid 44, and the bottom of the hole 114 has an air bleeder hole 127 defined therein in fluid communication with the air bleeder hole 45. Since the discharge port 34 is directed upwardly, the microfluidic chip 12 is housed in the recess 75 such that the glass substrate 16b lies on the bottom side of the holder member 63.

Instead of providing the air bleeder hole 127, as shown in FIG. 22, it is also preferable to employ a thinner holder member 63 and to have the lid 44 side of the electroosmotic pumps 14a through 14d projecting downwardly from the lower surface of the holder member 63.

As shown in FIGS. 20 and 21, after the electroosmotic pumps 14a through 14d have been housed in the respective holes 114 and the microfluidic chip 12 has been housed in the recess 75, the presser 106 is placed to cover the upper surface of the holder member 63 and a portion of the upper surface of the microfluidic chip 12 on the glass substrate 16a side, and the screws 108 are inserted through the holes 110 in the presser 106 and threaded into the holes 112 in the holder member 63. The presser 106 presses the microfluidic chip 12, which then presses the electroosmotic pumps 14a through 14d on the flange 126 side. The O-ring 120 provides a seal between the flange 126 and the glass substrate 16b. At the same time, the first terminal 122a and the third terminal 124a are electrically connected to each other, and the second terminal 122b and the fourth terminal 124b are electrically connected to each other.

The electroosmotic pump system 10F according to the sixth embodiment operates in the same manner and offers the same advantages as the electroosmotic pump system 10E (see FIGS. 18 and 19) according to the fifth embodiment described above.

An electroosmotic pump system 10G according to a seventh embodiment will be described below with reference to FIGS. 23 and 24.

The electroosmotic pump system 10G according to the seventh embodiment differs from the electroosmotic pump systems 10C through 10F according to the third through sixth embodiments (see FIGS. 11 through 22) in that the electroosmotic pumps 14a through 14d are partly inserted in sides of the holder member 63, and the first fluid passages 22 in the electroosmotic pumps 14a through 14d are held in fluid communication with the second fluid passage 18 in the microfluidic chip 12 through communication passages 130 defined in the holder member 63.

The electroosmotic pumps 14a through 14d are of substantially the same structure as the electroosmotic pump 14 (see FIGS. 11 and 12) according to the third embodiment. However, the electroosmotic pumps 14a through 14d are free of bosses 35 and have legs 132a, 132b projecting radially from the outer peripheral surfaces of the pump casings 24 near the discharge ports 34, and plug-shaped first and second terminals 134a, 134b are disposed so as to extend from the legs 132a, 132b toward the sides of the holder member 63.

The holder member 63 has the communication passages 130 defined therein which hold the bottom of the recess 75 and the sides of the holder member 63 in fluid communication with each other. The communication passages 130 have large-diameter portions at the sides of the holder member 63 for the insertion therein of the electroosmotic pumps 14a through 14d on the discharge port 34 side.

Socket-shaped third and fourth terminals 136a, 136b are disposed in the holder member 63 near the large-diameter portions in confronting relation to the first and second terminals 134a, 134b.

When the electroosmotic pumps 14a through 14d are inserted into the large-diameter portions of the communication passages 130, the portions of the electroosmotic pumps 14a through 14d from the discharge ports 34 to the legs 132a, 132b are accommodated in the large-diameter portions, bringing the discharge ports 34 and the communication passages 130 into fluid communication with each other. The first terminal 134a is fitted in the third terminal 136a, and the second terminal 134b is fitted in the fourth terminal 136b. The electroosmotic pumps 14a through 14d are now secured to and held on the sides of the holder member 63.

When the microfluidic chip 12 is housed in the recess 75 with the glass substrate 16b on the bottom thereof, the communication holes 36 and the communication passages 130 are held in fluid communication with each other. As a result, the first fluid passages 22 are held in fluid communication with the second fluid passage 18 through the communication passages 130.

With the electroosmotic pump system 10G according to the seventh embodiment, the microfluidic chip 12 and the electroosmotic pumps 14a through 14d are housed in the holder member 63, and the first fluid passages 22 and the second fluid passage 18 are held in fluid communication with each other through the communication passages 130 defined in the holder member 63. Therefore, the electroosmotic pumps 14a through 14d provide the same interfaces as the electroosmotic pumps 14, 14a through 14d of the electroosmotic pump systems 10C through 10G (FIGS. 11 through 22) according to the third through sixth embodiments described above. The overall system is thus further simplified.

An electroosmotic pump system 10H according to an eighth embodiment will be described below with reference to FIGS. 25 and 26.

The electroosmotic pump system 10H according to the eighth embodiment differs from the electroosmotic pump systems 10A, 10B according to the first and second embodiments (see FIGS. 1 through 10) in that a horizontal electroosmotic pump 14 is directly mounted on the microfluidic chip 12.

The electroosmotic pump 14 is of substantially the same structure as the electroosmotic pumps 14, 14a through 14d (see FIGS. 11, 12, 23, and 24) according to the third and seventh embodiments. However, the electroosmotic pump 14 is free of a boss 35 and legs 132a, 132b, and the discharge port 34 and the communication hole 36 are coupled to each other by a tube 142.

In FIG. 25, teeth 140a, 140b are disposed on the bottom of the electroosmotic pump 14 for securing the electroosmotic pump 14 to the glass substrate 16b. The tube 142 on the glass substrate 16b side is sealed by a seal member 144.

In FIG. 26, plug-shaped first and second terminals 150a, 150b are disposed on the bottom of the electroosmotic pump 14, and socket-shaped third and fourth terminals 152a, 152b are disposed in the glass substrate 16b in confronting relation to the first and second terminals 150a, 150b. When the first terminal 150a is fitted in the third terminal 152a and the second terminal 150b is fitted in the fourth terminal 152b, the electroosmotic pump 14 is reliably secured to the microfluidic chip 12. It is also possible to apply a voltage of one polarity from a power supply, not shown, to the first electrode 30 through the first terminal 150a and the third terminal 152a and a voltage of the opposite polarity from the power supply to the second electrode 32 through the second terminal 150b and the fourth terminal 152b.

With the electroosmotic pump system 10H according to the eighth embodiment, therefore, when the horizontal electroosmotic pump 14 is directly mounted on the microfluidic chip 12, the interfaces in the electroosmotic pump systems 10A, 10B according to the first and second embodiments (see FIGS. 1 through 10) are realized. As a result, the overall system arrangement is further simplified.

The electroosmotic pump system and the electroosmotic pump according to the present invention are not limited to the above embodiments, but may have various structures without departing from the gist of the present invention. Industrial applicability:

According to the present invention, an electroosmotic pump and a microfluidic chip are separate from each other, and the electroosmotic pump is directly mounted on the microfluidic chip by an attachment. The electroosmotic pump and the microfluidic chip are integrally combined with each other from the standpoint of reducing the size of the entire system. If the electroosmotic pump and the microfluidic chip are general-purpose products, then the entire system can be constructed at a low cost. Stated otherwise, the small-size electroosmotic pump is disposed more closely to the microfluidic chip than with the conventional arrangements. As a result, the entire system can be reduced in size for increased system mobility. Since the electroosmotic pump is detachably mounted on the microfluidic chip, the general versatility is increased and the entire system is low in cost.

Because the electroosmotic pump is directly mounted on the microfluidic chip, the tubes employed in the conventional arrangements are not required. As a result, the reagent is not wasted, and the minute amount of the fluid in the second fluid passage can be controlled with high accuracy. According to the present invention, therefore, more practical fluid control can be achieved at a lower cost than with the conventional arrangements.

Furthermore, the attachment functions as an interface for securing the electroosmotic pump to the microfluidic chip and also as an interface for supplying and drawing in the fluid between the electroosmotic pump and the microfluidic chip. Consequently, the overall system arrangement is simplified.

According to the present invention, the electroosmotic pump, the microfluidic chip, and the holder member are separate from each other. The electroosmotic pump is mounted on the holder member by the attachment, and the microfluidic chip is held on the holder member.

The electroosmotic pump, the microfluidic chip, and the holder member are integrally combined with each other from the standpoint of reducing the size of the entire system. If the electroosmotic pump, the microfluidic chip, and the holder member are general-purpose products, then the entire system can be constructed at a low cost. Stated otherwise, the small-size electroosmotic pump is disposed more closely to the microfluidic chip by the holder member than with the conventional arrangements. As a result, the entire system can be reduced in size for increased system mobility. Since the microfluidic chip and the electroosmotic pump are detachably mounted on the holder member, the general versatility is increased and the entire system is low in cost.

Because the electroosmotic pump is mounted on the holder member which holds the microfluidic chip, the distance between the electroosmotic pump and the microfluidic chip is smaller than with the conventional arrangements. As a consequence, the amount of a reagent which is wasted is reduced, and the minute amount of a fluid which is present in the second fluid passage can be controlled with high accuracy. According to the present embodiment, therefore, more practical fluid control can be achieved at a lower cost than with the conventional arrangements.

Furthermore, the attachment functions as an interface for securing the electroosmotic pump to the holder member and also as an interface for supplying and drawing in the fluid between the electroosmotic pump and the microfluidic chip. Consequently, the overall system arrangement is simplified.

## Claims

1. An electroosmotic pump system comprising:

    an electroosmotic pump (14, 14a through 14d) having an electroosmotic member (28) disposed in a first fluid passage (22), a first electrode (30) disposed on an upstream side of said electroosmotic member (28), and a second electrode (32) disposed on a downstream side of said electroosmotic member (28), with a discharge port (34) being defined downstream of said second electrode (32); and
    a microfluidic chip (12) having a second fluid passage (18) defined therein;
    wherein said electroosmotic pump (14, 14a through 14d) has on an outer peripheral surface thereof an attachment (35, 54a, 54b, 58a, 58b, 60a, 60b, 62a, 62b, 140a, 140b, 150a, 150b) for mounting said electroosmotic pump (14, 14a through 14d) on said microfluidic chip (12); and
    when said electroosmotic pump (14, 14a through 14d) is mounted on said microfluidic chip (12) by said attachment (35, 54a, 54b, 58a, 58b, 60a, 60b, 62a, 62b, 140a, 140b, 150a, 150b), said first fluid passage (22) is held in fluid communication with said second fluid passage (18) through said discharge port (34), and a fluid (38, 40, 42) between said first fluid passage (22) and said second fluid passage (18) is prevented from leaking.

2. An electroosmotic pump system according to claim 1, wherein said attachment (35, 54a, 54b, 58a, 58b, 60a, 60b, 62a, 62b) comprises a boss (35) projecting toward said microfluidic chip (12) and fittable in said second fluid passage (18) or a recess defined in confronting relation to said microfluidic chip (12) and fittable over said microfluidic chip (12); and
    said discharge port (34) is defined in said boss (35) or said recess.

3. An electroosmotic pump system according to claim 1 or 2, wherein said attachment (54a, 54b, 58a, 58b, 60a, 60b, 62a, 62b, 150a, 150b) has a first terminal (54a, 58a, 60a, 62a, 150a) electrically connected to said first electrode (30) and a second terminal (54b, 58b, 60b, 62b, 150b) electrically connected to said second electrode (32);
    said microfluidic chip (12) has on a surface thereof a third terminal (56a, 64a, 152a) confronting said first terminal (54a, 58a, 60a, 62a, 150a) and a fourth terminal (56b, 64b, 152b) confronting said second terminal (54b, 58b, 60b, 62b, 150b); and

when said electroosmotic pump (14, 14a through 14d) is mounted on said microfluidic chip (12) by said attachment (54a, 54b, 58a, 58b, 60a, 60b, 62a, 62b, 140a, 140b, 150a, 150b), said first terminal (54a, 58a, 60a, 62a, 150a) and said third terminal (56a, 64a, 152a) are connected to each other, and said second terminal (54b, 58b, 60b, 62b, 150b) and said fourth terminal (56b, 64b, 152b) are connected to each other.

4.  An electroosmotic pump system comprising:

   an electroosmotic pump (14, 14a through 14d) having an electroosmotic member (28) disposed in a first fluid passage (22), a first electrode (30) disposed on an upstream side of said electroosmotic member (28), and a second electrode (32) disposed on a downstream side of said electroosmotic member (28), with a discharge port (34) being defined downstream of said second electrode (32);
   a microfluidic chip (12) having a second fluid passage (18) defined therein; and
   a holder member (63) holding said microfluidic chip (12) and said electroosmotic pump (14, 14a through 14d);
   wherein said electroosmotic pump (14, 14a through 14d) has on an outer peripheral surface thereof an attachment (35, 61, 65a, 65b, 67, 100, 102a, 102b, 120, 122a, 122b, 134a, 134b, 138) for mounting said electroosmotic pump (14, 14a through 14d) on at least said holder member (63); and
   when said microfluidic chip (12) is mounted on said holder member (63) and said electroosmotic pump (14, 14a through 14d) is mounted on said holder member (63) by said attachment (35, 61, 65a, 65b, 67, 100, 102a, 102b, 120, 122a, 122b, 134a, 134b, 138), said first fluid passage (22) is held in fluid communication with said second fluid passage (18) through said discharge port (34), and a fluid (38, 40, 42) between said first fluid passage (22) and said second fluid passage (18) is prevented from leaking.

5.  An electroosmotic pump system according to claim 4, wherein said attachment (35, 61, 65a, 65b, 67, 120, 122a, 122b, 134a, 134b, 138) has a first terminal (65a, 102a, 122a, 134a) electrically connected to said first electrode (30) and a second terminal (65b, 102b, 122b, 134b) electrically connected to said second electrode (32);
   said microfluidic chip (12) has on a surface thereof a third terminal (66a, 104a, 124a, 136a) connectable to said first terminal (65a, 102a, 122a, 134a) and a fourth terminal (66b, 104b, 124b, 136b) connectable to said second terminal (65b, 102b, 122b, 134b); and
   when said electroosmotic pump (14, 14a through 14d) is mounted on said holder member (63, 63a through 63d) by said attachment (35, 61, 65a, 65b, 67, 120, 122a, 122b, 134a, 134b, 138), said first terminal (65a, 102a, 122a, 134a) and said third terminal (66a, 104a, 124a, 136a) are connected to each other, and said second terminal (65b, 102b, 122b, 134b) and said fourth terminal (66b, 104b, 124b, 136b) are connected to each other.

6.  An electroosmotic pump system according to claim 4, wherein said attachment (67, 100, 102a, 102b) has a seal member (100) disposed in confronting relation to said microfluidic chip (12) and surrounding said discharge port (34), a first terminal (102a) electrically connected to said first electrode (30), and a second terminal (102b) electrically connected to said second electrode (32);
   said electroosmotic pump (14a through 14d) is held by said holder member (63) through an electric connector member (80) having a third terminal (104a) connectable to said first terminal (102a) and a fourth terminal (104b) connectable to said second terminal (102b); and
   when said electric connector member (80) is secured to said holder member (63), said electric connector member (80) presses said microfluidic chip (12) through said electroosmotic pump (14a through 14d), and said seal member (100) provides a seal between said electroosmotic pump (14a through 14d) and said microfluidic chip (12).

7.  An electroosmotic pump system according to claim 4, wherein said attachment (120, 122a, 122b) has a seal member (120) disposed in confronting relation to said microfluidic chip (12) and surrounding said discharge port (34), a first terminal (122a) electrically connected to said first electrode (30), and a second terminal (122b) electrically connected to said second electrode (32);
   said holder member (63, 63a through 63d) has a recess (75, 118) defined therein for accommodating said microfluidic chip (12), a hole (114) held in fluid communication with said recess (75, 118) and accommodating said electroosmotic pump (14a through 14d), and a third terminal (124a) and a fourth terminal (124b) which are electrically connected to said first terminal (122a) and said second terminal (122b), respectively, when said electroosmotic pump (14a through 14d) is accommodated in said hole (114);
   when said electroosmotic pump (14a through 14d) is accommodated in said hole (114) and said microfluidic chip (12) is accommodated in said recess (75, 118), said microfluidic chip (12) is sandwiched by said holder member (63, 63a through 63d) and a presser (106); and
   said seal member (120) provides a seal between said electroosmotic pump (14a through 14d) and said microfluidic chip (12) when said presser (106) presses said electroosmotic pump (14a through 14d) through said microfluidic chip (12).

8. An electroosmotic pump system according to claim 4,
wherein said attachment (134a, 134b, 138) has a seal member (138) disposed in confronting relation to said holder member (63) and surrounding said discharge port (34), a first terminal (134a) confronting said holder member (63) and electrically connected to said first electrode (30), and a second terminal (134b) confronting said holder member (63) and electrically connected to said second electrode (32);
said holder member (63) has a recess (75) defined therein for accommodating said microfluidic chip (12), a communication passage (130) defined therein which accommodates therein a discharge port (34) side of said electroosmotic pump (14a through 14d) and which is connected to said recess (75), a third terminal (136a) fittable over said first terminal (134a), and a fourth terminal (136b) fittable over said second terminal (134b);
when said discharge port (34) side of said electroosmotic pump (14a through 14d) is accommodated in said communication passage (130) and said electroosmotic pump (14a through 14d) is mounted on said holder member (63) by said attachment (134a, 134b, 138), said first terminal (134a) and said third terminal (136a) are connected to each other, said second terminal (134b) and said fourth terminal (136b) are connected to each other, and said seal member (138) provides a seal between said electroosmotic pump (14a through 14d) and said holder member (63).

9. An electroosmotic pump system according to any one of claims 1 through 8, wherein said first fluid passage (22) has a liquid reservoir (26) for being filled with a liquid (38) supplied from an external source.

10. An electroosmotic pump system according to claim 9, wherein said liquid reservoir (26) is filled with said liquid (38) through an opening thereof, said opening being covered with a lid (44).

11. An electroosmotic pump system according to any one of claims 1 through 10, wherein a space extending from said discharge port (34) to said second fluid passage (18) has a volume v in the range of 10 [nl] < v < 10 [$\mu$l], or a distance from said discharge port (34) to said second fluid passage (18) ranges from 5 [$\mu$m] to 50 [mm].

12. An electroosmotic pump (14, 14a through 14d) having an electroosmotic member (28) disposed in a first fluid passage (22), a first electrode (30) disposed on an upstream side of said electroosmotic member (28), and a second electrode (32) disposed on a downstream side of said electroosmotic member (28), with a discharge port (34) being defined downstream of said second electrode (32);
wherein said electroosmotic pump (14, 14a through 14d) has on an outer peripheral surface thereof an attachment (35, 54a, 54b, 58a, 58b, 60a, 60b, 61, 62a, 62b, 65a, 65b, 67, 100, 102a, 102b, 120, 122a, 122b, 134a, 134b, 138, 140a, 140b, 142, 144, 150a, 150b) for mounting said electroosmotic pump (14, 14a through 14d) on said microfluidic chip (12) or mounting said electroosmotic pump on a holder member holding said microfluidic chip; and
when said electroosmotic pump (14, 14a through 14d) is mounted on said microfluidic chip (12) or said holder member (63) by said attachment (35, 54a, 54b, 58a, 58b, 60a, 60b, 61, 62a, 62b, 65a, 65b, 67, 100, 102a, 102b, 120, 122a, 122b, 134a, 134b, 138, 140a, 140b, 142, 144, 150a, 150b), said first fluid passage (22) is held in fluid communication with a second fluid passage (18) defined in said microfluidic chip (12) through said discharge port (34), and said attachment (35, 54a, 54b, 58a, 58b, 60a, 60b, 61, 62a, 62b, 65a, 65b, 67, 100, 102a, 102b, 120, 122a, 122b, 134a, 134b, 138, 140a, 140b, 142, 144, 150a, 150b) prevents a fluid (38, 40, 42) between said first fluid passage (22) and said second fluid passage (18) from leaking.

13. An electroosmotic pump according to claim 12, wherein said first fluid passage (22) has a liquid reservoir (26) for being filled with a liquid (38) supplied from an external source.

14. An electroosmotic pump according to claim 13, wherein said liquid reservoir (26) is filled with said liquid (38) through an opening thereof, said opening being covered with a lid (44).

# FIG. 1

<u>10A</u>

# FIG. 2

14a (b, c, d)

26

22

TO POWER SUPPLY

30  31

24

28

TO POWER SUPPLY

32
34
33
36  12  16b

35

38  42  18  40  16a

# FIG. 3

TO POWER SUPPLY

TO POWER SUPPLY

14a (b, c, d)

# FIG. 4

DIRECTION OF
ELECTRIC FIELD E

# FIG. 5A

FLOW RATE
($\mu$L/min)

● :MEASURED VALUES
— :REGRESSION LINE

DRIVE
VOLTAGE (V)

# FIG. 5B

FLOW RATE
($\mu$L/min)

● :MEASURED VALUES
— :REGRESSION LINE

PRESSURE (kPa)

# FIG. 6

14a (b, c, d)

26

22

TO POWER
SUPPLY

30    31

24

28

TO POWER
SUPPLY

32

33

36

34

17

12    16b

38    42   18   40   16a

# FIG. 7

# FIG. 8

14a (b, c, d)

58b

35

58a

34

12

56b

36

56a

16b

16a

# FIG. 9

# F I G. 10

14a (b, c, d)

24

62b

62a

35

34

64b

64a

12

16b

TO POWER
SUPPLY

TO POWER
SUPPLY

36

# FIG. 11

10C

EP 1 795 258 A1

# FIG. 12

TO POWER
SUPPLY

TO POWER
SUPPLY

# FIG. 13

# FIG. 14

## FIG. 15

# FIG. 16

# F I G. 17

# FIG. 18

# FIG. 19

<u>10E</u>

14a (b, c, d)

TO POWER SUPPLY    TO POWER SUPPLY

## FIG. 20

10F

FIG. 21

TO POWER
SUPPLY

TO POWER
SUPPLY

EP 1 795 258 A1

# FIG. 22

TO POWER
SUPPLY

TO POWER
SUPPLY

14a (b, c, d)

FIG. 23

FIG. 24

EP 1 795 258 A1

EP 1 795 258 A1

FIG. 25

10H

TO POWER
SUPPLY

FIG. 26

# FIG. 27

# FIG. 28

# FIG. 29

# FIG. 30

208a (b, c, d)
238
210
232
218
220
216
234
236
240

# FIG. 31

250

TO POWER SUPPLY

TO POWER SUPPLY

254

218

252

262

264

210

258

216

256

260

# FIG. 32

## INTERNATIONAL SEARCH REPORT

| | International application No. |
|---|---|
| | PCT/JP2005/010432 |

A. CLASSIFICATION OF SUBJECT MATTER
    Int.Cl⁷ B01J19/00, B81B1/00, G01N35/08, 37/00

According to International Patent Classification (IPC) or to both national classification and IPC

B. FIELDS SEARCHED

Minimum documentation searched (classification system followed by classification symbols)
    Int.Cl⁷ B01J19/00, B81B1/00, G01N35/08, 37/00

Documentation searched other than minimum documentation to the extent that such documents are included in the fields searched
    Jitsuyo Shinan Koho        1922-1996   Jitsuyo Shinan Toroku Koho   1996-2005
    Kokai Jitsuyo Shinan Koho   1971-2005   Toroku Jitsuyo Shinan Koho   1994-2005

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y<br>A | JP 9-281077 A (Hitachi, Ltd.),<br>31 October, 1997 (31.10.97),<br>Claims; Par. Nos. [0025] to [0028]<br>(Family: none) | 1,2,4,9-14<br>3,5-8 |
| Y<br>A | WO 2002/064247 A1 (MERCK PATENT GMBH),<br>22 August, 2002 (22.08.02),<br>Full text<br>& JP 2004-529749 A    & US 2004/0074084 A1 | 1,2,4,9-14<br>3,5-8 |
| A | JP 2004-113223 A (Jun KIKUCHI),<br>15 April, 2004 (15.04.04),<br>Full text<br>(Family: none) | 1-14 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 23 August, 2005 (23.08.05) | 13 September, 2005 (13.09.05) |

| Name and mailing address of the ISA/ | Authorized officer |
|---|---|
| Japanese Patent Office | |
| Facsimile No. | Telephone No. |

Form PCT/ISA/210 (second sheet) (January 2004)

54

**EP 1 795 258 A1**

**INTERNATIONAL SEARCH REPORT**

International application No.

PCT/JP2005/010432

C (Continuation). DOCUMENTS CONSIDERED TO BE RELEVANT

| Category* | Citation of document, with indication, where appropriate, of the relevant passages | Relevant to claim No. |
|---|---|---|
| A | JP 10-10088 A (Hitachi, Ltd.),<br>16 January, 1998 (16.01.98),<br>Full text<br>(Family: none) | 1-14 |

Form PCT/ISA/210 (continuation of second sheet) (January 2004)

55

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **ZHEN YANG ; RYUTARO MAEDA.** A world-to-chip socket for microfluidic prototype development. *Electrophoresis,* 2002, vol. 23, 3474-3478

- **MICHAEL KOCH ; ALAN EVANS ; ARTHUR BRUNNSCHWEILER.** Microfluidic Technology and Applications. Research Studies Press Inc, 2000